(19) **Europäisches Patentamt / European Patent Office / Office européen des brevets**

(11) **EP 3 343 619 A1**

(12) # EUROPEAN PATENT APPLICATION

(43) Date of publication:
04.07.2018 Bulletin 2018/27

(51) Int Cl.:
*H01L 27/146* (2006.01)  *G02B 27/56* (2006.01)

(21) Application number: 16306844.8

(22) Date of filing: 29.12.2016

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(71) Applicant: **Thomson Licensing**
**92130 Issy-les-Moulineaux (FR)**

(72) Inventors:
• **BORISKIN, Artem**
**35576 CESSON-SEVIGNE (FR)**

• **BLONDE, Laurent**
**35576 CESSON-SEVIGNE (FR)**
• **SCHUBERT, Arno**
**35576 CESSON-SEVIGNE (FR)**
• **DAMGHANIAN, Mitra**
**35576 CESSON-SEVIGNE (FR)**

(74) Representative: **Huchet, Anne**
**TECHNICOLOR**
**1-5, rue Jeanne d'Arc**
**92130 Issy-les-Moulineaux (FR)**

(54) **AN IMAGE SENSOR COMPRISING AT LEAST ONE SENSING UNIT WITH LIGHT GUIDING MEANS**

(57)  The present disclosure concerns an image sensor comprising at least one sensing unit, said at least one sensing unit comprising means for converting light into a readable electric signal. The image sensor is remarkable in that said at least one sensing unit comprises light guiding means for guiding light in direction to said means for converting light into a readable electric signal, said light guiding means comprising:
- at least one layer of a dielectric material, having a first refractive index with a surface having at least one abrupt change of level forming a step, and
- an element having a second refractive index lower than said first refractive index, which is in contact with said step.

$$P > W > \lambda/4$$
$$H > \lambda/2$$

Figure 41(b)

**Description**

Technical Field

The present disclosure relates to the field of image sensing devices and, more particularly, to a technique (and related components) for increasing the light capture efficiency of the image sensors.

Background

This section is intended to introduce the reader to various aspects of art, which may be related to various aspects of the present invention that are described and/or claimed below. This discussion is believed to be helpful in providing the reader with background information to facilitate a better understanding of the various aspects of the present invention. Accordingly, it should be understood that these statements are to be read in this light, and not as admissions of prior art.

Image sensors (or image sensing devices) are widely used in consumer electronic devices such as smartphones and various digital cameras. At present, there are two types of image sensor available for mass products, namely CCD (charge coupled devices) and CMOS (complementary metal-oxide-semiconductor). Each typically includes an array of pixels containing photo sensors.

A pixel may be constructed in various known ways. Generally, a pixel is constructed of a material, which converts image light into electrical signals, which can then be processed and stored in the circuitry of the digital camera.

Usually, a pixel contains a light sensitive region and one or more non-light sensitive regions. The ratio of light sensitive, or active, regions to the total area of the pixel is referred to as the fill factor. The light sensitive region may comprise a portion of a silicon wafer, which is surrounded by support circuitry such as polysilicon gates, metal conductors, channel stops, light shields, etc., forming a pit. The image light must travel down through the pit to the bottom where the light sensitive region is located.

It should be noted that CMOS pixels can be classified into two categories: the frontside illuminated (FSI) structure and the backside illuminated (BSI) structure. In the FSI structure, incident light first passes through a metal layer (comprising circuitry and metal wires) before reaching a photoactive region of a pixel comprised in a silicon layer, whereas in a BSI structure, the position of the metal layer is flipped with the position of the photoactive region of the pixel. Therefore, a BSI structure detects a higher amount of light compared to a FSI structure, and so the BSI structure has a higher light capture efficiency. In addition, optical crosstalk in a FSI structure can occur when a photon intended for one pixel gets bounced into an adjacent pixel instead, due to the metal layer. Such optical crosstalk reduces the image sharpness. In addition, a BSI structure can also capture a wider cone of light compared to a FSI structure, and the silicon layer used in a BSI structure is smaller than the one in a FSI structure.

In order to improve the sensitivity of the FSI structure, it has been proposed to use light guide (formed in various layers of a dielectric stack and comprising a material that has a higher index of refraction compared to the ones of the dielectric layers) as reminded in the article "SNR Performance Comparison of $1.4\mu$m Pixel: FSI, Light-guide, and BSI" by Kyungho Lee et al, or in the documents US 9478574, US2010308427 and US2012200749.

In addition, in order to improve the light capture efficiency of an image sensor, several techniques and approaches have been developed in the past that can be used on CMOS pixels.

In the document CN 105791714, it is proposed to modify the size of the pixels within an image sensor according to its location inside an image sensor. Hence, the size of pixel units in the image sensor is not exactly the same inside such image sensor. More precisely, the size of peripheral pixel units is increased compared to the pixel units located close to the center of the image sensor. Such architecture increases the luminous flux of each pixel unit (see for example the Figure 4 of CN105791714).

In document US 9497397, it is proposed to improve the efficiency of an image sensor by using a shielding element positioned over portions of at least two photodetectors, each photodetector being associated with a pixel. Such shielding element is made of an opaque material and enables to prevent the occurrence of crosstalk effect (see the figure 6 of document US 9497397). Hence, the reduction of crosstalk effect enables the improvement of the image sensor.

Another way to improve the efficiency of an image sensor is to increase the light gathering performed by an image sensor via the use of a refractive focusing layer (that can be merged with a color filter layer) as mentioned in document US 2016126277. Such refractive focusing layer may comprise a heterogenous (in term of refractive index distribution) optical film, with alternating parts/regions having either high refractive index or low refractive indexes (see for example the Figure 3 of document US 2016126277).

Another way to improve the light capture efficiency of a pixel can be achieved by covering pixels with microlenses (ML) (see for example the Figure 1 of document US 2015/0325618). Such microlens (ML) directs the incoming image light through the pit to the light sensitive region at the bottom. A microlens is a small lens with approximately the same area as the entire associated pixel. The microlens is positioned above the pixel aiming to gather a maximum of the image light incident on the pixel and directing it to the light sensitive region of the pixel. It should be noted that different types of color filters can be employed to capture different wavebands, placed over the pixels of an image sensor to capture color information. The light capture efficiency of the pixel may depend on many factors, including the focusing efficiency of the microlens, namely its ability to direct the image light to the light sensitive region under different illumination conditions that may differ depending on (i) the objective lens employed to collimate the image light captured by a camera and (ii) the location of the pixel on the sensor array.

It should be noted that the use of microlenses in an image sensor may be combined to other technique as explained in the following.

In the document US2016013229, it is proposed to use filter unit (disposed on a sensing layer comprising photodiodes, and below microlenses) with material having a gradient refractive index (see the Figures 1 and 2 of document US2016013229) enabling the increase of the sensitivity of the image sensor (the gradient refractive index is gradually increased from the bottom surface of the filter unit (close to the sensing layer) to the top surface of the filter unit (close to the microlenses)).

Moreover, in document CN204011428, it is proposed to use additional backside microlenses (see Figure 13 of document CN204011428) in addition with shadow groove isolation slots disposed between adjacent photosensitive devices in order to reduce the crosstalk effect.

Another technique described in the article entitled: "Plasmonic Color Filters for CMOS Image Sensor Applications" by Sozo Yokogawa et al., proposes to modify again a filter unit (especially the color filter) by using hole array filters in which plamonic effect occurs. Such technique enables the improvement of the transmission efficiency. For reminders, the plamonic effect only occurs for metal material (see for example the PhD Thesis entitled "Plasmonic devices for surface optics and Refractive Index Sensing" by Benedikt Stein). The technique of document US 20140191113 has a similar approach by using a metal film with nano-holes which is disposed over pixels.

At last, in document US 20150311243, it is proposed an image sensor comprising either chromatic pixels and achromatic pixels. Each chromatic pixel corresponds to a photodiode embedded in a substrate, and covered by a color filter, and each achromatic pixel corresponds to a photodiode also embedded in the same substrate, but such achromatic pixel is not covered by a color filter, and it has a nanopillar pattern at the surface region of the substrate (that could have a wide variety of shapes such as cylindrical shape, or polygonal shape, or polygonal cone shape. Such nanopillar patterns increase the optical absorption of the photodiode of an achromatic pixel. It should be noted that here again the surface layer of the substrate is a P-type semiconductor layer (see Figures 1 and 9 of document US 20150311243).

Hence, there is a need to provide an alternative technique to the ones previously presented, that may overcome some of their limitations.

Summary of the disclosure

References in the specification to "one embodiment", "an embodiment", "an example embodiment", indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

In one embodiment of the disclosure, it is proposed an image sensor comprising at least one sensing unit, said at least one sensing unit comprising means for converting light into a readable electric signal. The image sensor is remarkable in that said at least one sensing unit comprises light guiding means for guiding light in direction to said means for converting light into a readable electric signal, said light guiding means comprising:

- at least one layer of a dielectric material (112), having a first refractive index ($n_1$) with a surface having at least one abrupt change of level forming a step, and
- an element having a second refractive index ($n_2$) lower than said first refractive index ($n_1$), which is in contact with said step.

It should be noted that the step generates (due to its position and the relationship existing between the first and second indexes) a nanojet beam when an electromagnetic wave is incident on said light guiding means. The orientation of the nanojet beam is directed to the means for converting light into a readable electric signal. Therefore, such technique enables to capture more light compared to the ones from the prior art.

Hence, the light guiding means cannot be considered as standard refractive microlenses used in an image sensor due to the features (material and shape) related to the features of light guiding means. In addition, the techniques that benefit from the use of the plasmonic effect rely on the use of noble metals. Hence, the physical phenomena associated with transmission of light through the holes in a metallic layer and the light guiding phenomena associated with the presence of a step in a dielectric material with the two refractive indexes are not the same.

In a preferred embodiment, the image sensor further comprises at least two sensing units, and wherein the light guiding means of each of these two sensing units are at least partly positioned close to an interface region separating the two sensing units.

In a preferred embodiment, the image sensor further comprises at least two microlenses, each microlens covering a sensing unit, and wherein the light guiding means of each of these two sensing units are at least partly positioned in a neighborhood of said at least two microlenses.

In a preferred embodiment, the image sensor is remarkable in that said light guiding means completely cover a top of said at least one sensing unit, the top of said at least one sensing unit being a part distant from the means for converting light into a readable electric signal compared to other parts of said at least one sensing unit.

Hence, in one embodiment of the disclosure, the light guiding means can be an alternative to the use of microlenses in an image sensor and outreach the performance of standard refractive microlenses in terms of light capture efficiency.

In a preferred embodiment, the image sensor is remarkable in that said means for converting light into a readable electric signal correspond to at least one photodiode.

In a preferred embodiment, the image sensor further comprises a color filter, and wherein said light guiding means are positioned either below or above or merged with said color filter.

In a preferred embodiment, the image sensor is remarkable in that said at least one sensor unit corresponds to a CMOS image pixel.

In a preferred embodiment, the image sensor is remarkable in that said step is formed by an edge of at least one cavity made in said at least one layer of dielectric material, and said cavity is at least partly filled in with said element.

In a preferred embodiment, the image sensor is remarkable in that said at least one cavity is a through-hole in said at least one layer of dielectric material, and it comprises a substrate layer supporting said at least one layer of dielectric material.

Hence, in such embodiment of the disclosure, the image sensor comprises a groove pattern.

In a preferred embodiment, the image sensor is remarkable in that said at least one cavity belongs to at least one set of at least two cavities.

In a preferred embodiment, the image sensor is remarkable in that said at least one cavity is targeted to be cylindrical or cone or prism-shaped.

In a preferred embodiment, the image sensor is remarkable in that said cavity is targeted to be circular or polygonal cylindrical shaped, or circular cone or polygonal cone shaped.

In a preferred embodiment, the image sensor is remarkable in that a width W of said at least one cavity, in a cross-section, is targeted to be such that $W > \frac{\lambda_1}{2}$, where $\lambda_1$ is a minimum wavelength of an electromagnetic wave incident on said dielectric material.

In a preferred embodiment, the image sensor is remarkable in that a height H of said step is targeted to be such that $H > \frac{\lambda_1}{2}$, where $\lambda_1$ is a minimum wavelength of an electromagnetic wave incident on said dielectric material.

In a preferred embodiment, the image sensor is remarkable in that said dielectric material belongs to the group of materials with low dielectric loss comprising:

- glass;
- plastic;
- a polymer material;
- an organic or inorganic optically transparent electrically conducting material;
- ceramics.

In a preferred embodiment, the image sensor is remarkable in that said element having said second refractive index lower than the one of said dielectric material belongs to the group comprising:

- glass;
- plastic;
- polymer;
- a liquid;
- a gas;
- a gel.

In a preferred embodiment, it is proposed an electronic device for acquiring image data, said electronic device being characterized in that it comprises an image sensor as previously mentioned.

Brief description of the drawings

The above and other aspects of the invention will become more apparent by the following detailed description of exemplary embodiments thereof with reference to the attached drawings in which:

- **Figure 1(a)** presents a cross section of three pixels (comprised in a CMOS image sensor covered by microlenses) where said three pixels have a FSI structure;
- **Figure 1(b)** presents the loss of light induced by classical neighboring pixels;
- **Figure 2** illustrates a technique according to one embodiment of the disclosure, where an abrupt change occurs in the level of the surface of a dielectric layer 112, thus forming a step in the layer. **Figure 2(a)** shows a side view of the dielectric layer 112. **Figures 2(b)** and **2(c)** respectively show top views in case of a step with a straight (**figure 2(b)**) and curved (**figure 2(c)**) edge lines;
- **Figures 3(a) to 3(c)** are schematic drawings of the field intensity distribution in the imaging plane for three exemplary cylindrical cavities with different cross-sections illuminated by a plane wave propagating along z-axis, i.e. from the plane of the figure;
- **Figure 4** illustrates the topology and notations of a cavity formed in a layer of dielectric material according to an embodiment of the present disclosure;
- **Figures 5 (a) to 5 (e)** illustrate the formation of a nanojet beam by the hollow cylindrical cavity of **figure 4**, having a circular cross-section, when illuminated by a plane wave at different wavelengths ($n_1$ = 1.49, $n_2$ = 1);
- **Figures 6 and 7** provide an analysis of the nanojet beam radiation angle of **figures 5(a) to 5(e)**;
- **Figures 8(a) and 8(b)** illustrate the complex electromagnetic phenomenon underlying at least some embodiments of the present disclosure;
- **Figures 9(a) to 9(c)** illustrate near-field maps of the nanojet beam produced by hollow cylindrical cavities of different heights when illuminated by a unit-amplitude plane wave from below according to embodiments of the present disclosure ($n_1$ = 1.49, $n_2$ = 1);
- **Figures 10(a) to 10(d)** show nanojet beams produced by a hollow cylindrical cavity under different angles of incidence of the unit-amplitude $E_y$ plane wave in XZ-plane ($n_1$ = 1.49, $n_2$ = 1 );
- **Figures 11 (a) and 11 (b)** illustrate the nanojet beams phenomenon as observed for different host media according to embodiments of the present disclosure;
- **Figure 12** shows four exemplary cylindrical cavities each having a different shape of its cross-section boundary, namely: (a) circular, (b) square, (c) 8-shape, and (d) rectangular, according to embodiments of the present disclosure;
- **Figures 13(a) to 13(d)** show the corresponding simulated near-field maps for each cavity of **figure 12 -** top row: views from the side, bottom row: views from above;
- **Figure 14** presents a schematic drawing and compares a cavity composed of a single-core hollow cylinder (**Figure 14(a))** and a double-layer ring-type structure with a core filled in with the host medium according (**Figure 14(b)**) to one embodiment of the disclosure. The arrows schematically indicate propagation directions for the nanojet beams originating from different segments of the cavities base edge lines;
- **Figures 15 (a)** and **(b)** present the topology and notations of the ring-type nanojet elements/components according to one embodiment of the disclosure;
- **Figure 16** presents a ring-type nanojet element according to one embodiment of the disclosure ($n_1$ = 1, $n_2$ = 1.49): **(a)** Side view and notations, **(b)** Power density distribution along z-axis for the element with dimensions $L_z$ = 740nm, $R_1$ = 370nm, W = 500nm, **(c, d)** Power density distribution in the xz (y=0) and xy (z=80nm from top surface) planes;
- **Figure 17** presents near-field characteristics of the ring-type nanojet element according to one embodiment of the disclosure, with dimensions $R_1$ = 370nm, W = 500nm, refractive indexes $n_1$ = 1, $n_2$ = 1.49, and variable height illuminated by a unit-amplitude plane wave with $\lambda_0$=550nm: **(a)** Power density distribution along z-axis, **(b-e)** Power density distribution in xz (y=0) plane for the element height of $L_z$ = 370, 550, 740, and 1100 nm;
- **Figure 18** presents the power density distribution for the ring-type nanojet element according to one embodiment of the disclosure, with dimensions $L_z$ = 740nm, $R_1$ = 370nm, W = 500nm and refractive indexes ($n_1$ = 1, $n_2$ = 1.49) illuminated by a unit-amplitude plane wave with $\lambda_0$ =550nm under different incident angles: **(a)** along the x-axis (y=z=0), **(b-e)** in xz-plane for incident angles of 0°, 10°, 20°, 30°, respectively;

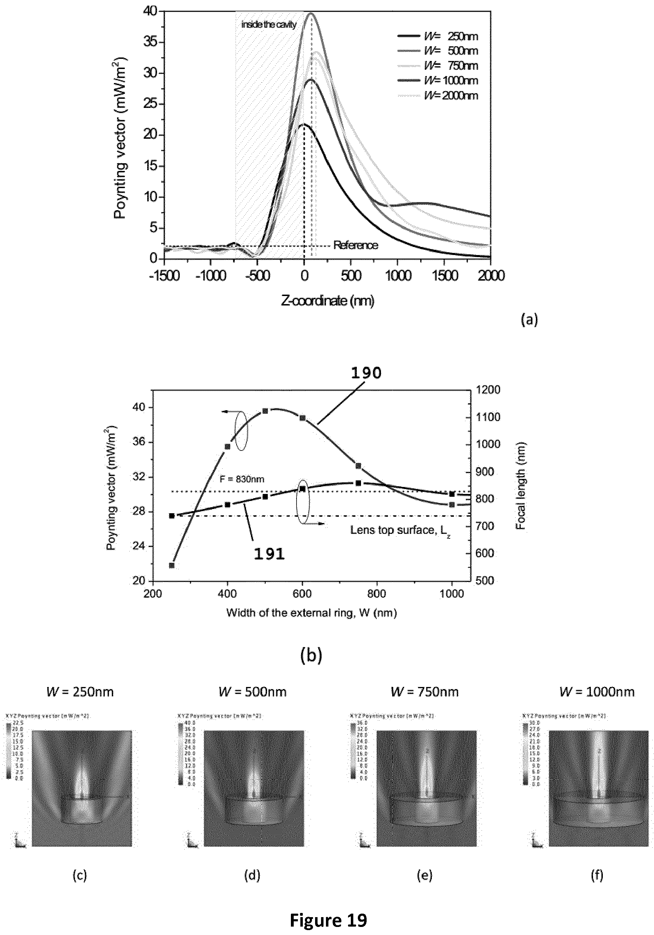

- **Figure 19** presents different nanojet beams produced by ring-type element, according to one embodiment of the disclosure, with dimensions $L_z$ = 740nm, $R_1$ = 370nm, refractive indexes ($n_1$ = 1, $n_2$ = 1.49) and variable width of the ring illuminated by a unit-amplitude plane wave with $\lambda_0$ =550nm: **(a)** power density distribution along z-axis, **(b)** maximum value of the power density along z-axis (curve referenced 190, left axis) and focal distance (curve referenced 191, right axis) versus width of the ring, **(c-f)** power density distributions in the xz-plane for W = 250, 500, 750, and 1000 nm;

- **Figure 20** presents different power density distributions for the ring-type nanojet element, according to one embodiment of the disclosure, with dimensions $R_1$ = 370nm, $L_z$ = 370nm, refraction indexes ($n_1$ = 1, $n_2$ = 1.49), and variable width of the ring illuminated by a unit amplitude plane wave with $\lambda_0$ =550nm: **(a)** along z-axis, **(b-e)** in xz-plane for W = 125, 250, 370, and 500 nm, respectively;
- **Figures 21 (a)-(c)** present different normalized power density distributions in the xz-plane for the ring-type nanojet element with dimensions $R_1$ = 370nm, $L_z$ = 370nm, W = 500nm, refraction indexes ($n_1$ = 1, $n_2$ = 1.49), and variable ring width illuminated by a unit-amplitude plane wave: **(a)** $\lambda_0$ =450nm, **(b)** $\lambda_0$ =550nm, **(c)** $\lambda_0$ =650nm;
- **Figures 22 (a)-(c)** presents, for the same wavelength of **Figure 21**, different normalized power density distributions in the xz-plane for the ring-type nanojet element with dimensions $R_1$ = 370nm, $L_z$ = 740nm, W = 500nm and refraction indexes ($n_1$ = 1, $n_2$ = 1.49) illuminated by a unit-amplitude plane wave: **(a)** $\lambda_0$ =450nm, **(b)** $\lambda_0$ =550nm, **(c)** $\lambda_0$ =650nm;
- **Figure 23** presents **(a)** a geometry of the ring-type nanojet element with circular and square rings, **(b)** the power density distribution along z-axis for the ring-type nanojet elements with circular and rectangular cross-sections and dimension of $L_z$ = 740nm, $R_1$ = 370nm, $L_x=L_y=2(R_1+W)$ illuminated by a unit-amplitude plane wave with $\lambda_0$ =550nm, **(c,d)** power density distributions for both elements in the xz-plane;
- **Figure 24** discloses the contour plots of the power density in a fixed point (0,0,100nm) located close to the ring-type element top surface versus element core radius and height. The element has a fixed width is of the ring W = 500nm and is illuminated by a unit-amplitude plane wave. The refraction indexes of the media: **(a)** $n_1$ = 1, $n_2$ = 1.49, **(b)** $n_1$ = 2.0;
- **Figure 25** presents different topologies of the exemplary ring-type nanojet elements;
- **Figures 26 (a) to (d)** present power density distribution in xz and xy-planes for the ring-type nanojet elements ($L_z$ = 740nm, W = 500nm, $n_1$ = 1, $n_2$ = 1.49) with different cross-sections of the core cylinder illuminated by a unit-amplitude plane wave $\lambda_0$ =550nm: **(a)** circle: $R_1$ = 370nm, **(b)** square: $L_x=L_y=2R1$, (c) 8-shape: $R_1$ = 370nm with a distance between the centers d=$R_1$, **(d)** rectangle: $L_x$ = 8$R_1$, $L_y=2R_1$;
- **Figure 27** presents different power density distribution along z-axis (x=y=0) for the ring-type nanojet elements with different cross-sections of the core cylinder presented in **Figure 26**;
- **Figures 28(a)-(d)** present different power density distributions along xz and yz-axis for the ring-type nanojet elements with different cross-sections presented in **Figure 25**;
- **Figure 29** presents two different views of a second element according to one embodiment of the disclosure;
- **Figure 30** presents a second element according to one embodiment of the disclosure whose base edge line comprises (at least) two pairs of opposite edge line segments contributing to creation of (at least) two nanojet beams;
- **Figure 31** presents the intersection of a part of the device according to the disclosure by a plane that is parallel to the propagation direction of an incident electromagnetic wave (and more precisely in that case with a normal incident electromagnetic wave with regards to the bottom of dielectric layer);
- **Figures 32 (a)-(d)** present different resulting intersections of a part of the device according to the disclosure, by a plane that is parallel to the propagation of an electromagnetic wave (and more precisely in that case with a normal incident electromagnetic magnetic wave with regards to the bottom of dielectric layer);
- **Figure 33** presents schematic drawings of the nanojet beams produced by a device (or ring-type nanojet element), according to one embodiment of the disclosure, that is illuminated by a unit-amplitude plane wave: **(a)** which is incident from below, along z-axis, **(b)** which is incident from left, along x-axis. The arrows from the first element indicate the nanojet beams. **Figure 33(c)** presents the power density distribution in xz-plane when the device according to one embodiment of the disclosure (i.e. comprising the ring structure) is illuminated from the left (along x axis);
- **Figure 34(a)** present a CAD model of a hollow ring-type NJ element having a form of a double-layer circular cylinder (R1 = 300nm, R2 = 700nm, H = 500nm) created in glass plate (n1 = 1.5nm) placed on top of a photoresist layer (n2 = 1.7), **figure 34(b)** presents a normalized field intensity in YZ-plane when illuminated by a plane wave ($\lambda_0$ = 365 nm) from above, **figure 34(c)** presents a normalized field intensity distribution along X and Y axes at Z = -100 nm, and **figure 34(d)** presents a normalized field intensity distribution along Z-axis;
- **Figure 35** presents (a) a normalized field intensity in XZ-plane for the ring-type NJ microlens illuminated by a plane wave ($\lambda$ = 365 nm) under 20° if defined with respect to the vertical axis, and (b) a normalized field intensity distribution along X-axis at Y = 0 nm, Z = -100 nm for two different incident angles of the plane wave. Parameters of the structure are the same as in Figure 36;
- **Figure 36** illustrates a specific embodiment of the present disclosure, according to which the focusing component is based on a 2x2 planar array of identical hollow cuboid-shaped cavities embedded in a host medium;
- **Figure 37** illustrates an alternate embodiment, in which the hollow cuboid-shaped cavities of figure 36 are replaced with hollow circular cylinders, oriented along the plane wave propagation direction;
- **Figure 38** illustrates yet another embodiment, in which a 2x2 array of hollow circular cylinders is created at the boundary of the dielectric medium and free space;

- **Figure 39** provides two additional exemplary embodiments based on single-periodic (figure 39a) and double-periodic (figure 39b) arrays of hollow cylinders embedded in a host medium;
- **Figure 40(a)** presents a cross section of three pixels (comprised in a CMOS image sensor covered by microlenses) according to the present disclosure, where the three pixels have a FSI structure, and where a nanojet focusing element (or light guiding means) is integrated in order to guide light that was lost in the prior art (especially in view of Figure 1(a));
- **Figure 40(b)** presents the guiding of loss light in Figure 1(b) via light guiding means according to the present disclosure;
- **Figure 41 (a)** presents a pixel architecture that can avoid the use of microlenses due to the use of light guiding means according to one embodiment of the disclosure;
- **Figure 41 (b)** presents a cross section of a part of a sensing unit (or pixel unit) according to one embodiment of the disclosure;
- **Figure 42** presents a schematic view (top view) of three different embodiments of an image sensor with nanojet focusing elements located at the boundaries of neighboring pixels (not to scale, the NJ microlenses are shown only for the central pixel of a 3x3 subarray);
- **Figure 43** presents: **(a)** a nanojet focusing element in a form of a ring-type cavity in an unbounded dielectric medium, **(b)** the prior art refractive microlens on top of a dielectric substrate, **(c)** a rectangular ring-type nanojet focusing element in a form of a groove on top surface on the substrate, **(d)** a combination of a refractive lens and a nanojet focusing element on the substrate;
- **Figure 44** discloses several topology and notations of the nanojet focusing element in the form of a ring-type cavity in a dielectric host medium: **(a)** top view on the periodic array, **(b)** 3-D model of the array unit cell with a ring-type nanojet focusing element, **(c)** side view of the unit cell and notations;
- **Figure 45** discloses several topology and notations of a simplified model of a pixel with refractive and nanojet focusing element: **(a)** top view on the periodic array, **(b)** 3-D model of the pixel with refractive microlens and nanojet focusing element, **(c)** side view of the pixel and notations;
- **Figure 46** presents normalized near-field intensity patterns of the ring-type nanojet focusing element illustrated in Figure 44 in the vertical XZ and horizontal XY planes when illuminated by a plane wave from above computed using 3D-FDTD method: **(a)** at 450 nm, **(b)** at 550 nm, **(c)** at 650 nm;
- **Figure 47** presents normalized near-field intensity patterns of the ring-type nanojet focusing element in a form of a groove on top of the substrate (see notations in Figure 45) in the vertical XZ and horizontal XY planes when illuminated by a plane wave from above computed using 3D-FDTD method: **(a)** at 450 nm, **(b)** at 550 nm, **(c)** at 650 nm;
- **Figure 48** presents normalized near-field intensity patterns of a refractive hemispherical microlens on top of the substrate (see notations in Figure 45) in the vertical XZ and horizontal XY planes when illuminated by a plane wave from above computed using 3D-FDTD method: **(a)** at 450 nm, **(b)** at 550 nm, **(c)** at 650 nm;
- **Figure 49** presents normalized near-field intensity patterns of the combined nanojet focusing elements comprising a hemispherical refractive microlens and NJ microlens in a form of a groove (see notations in Figure 45) in the vertical XZ and horizontal XY planes when illuminated by a plane wave of from above computed using 3D-FDTD method: (a) at 450 nm, (b) at 550 nm, (c) at 650 nm;
- **Figure 50** presents the light capture efficiency of the pixels presented in Figures 46-49 determined from the ratio between the power incident on the receiving aperture and the total power received by the full aperture.

<u>Detailed description</u>

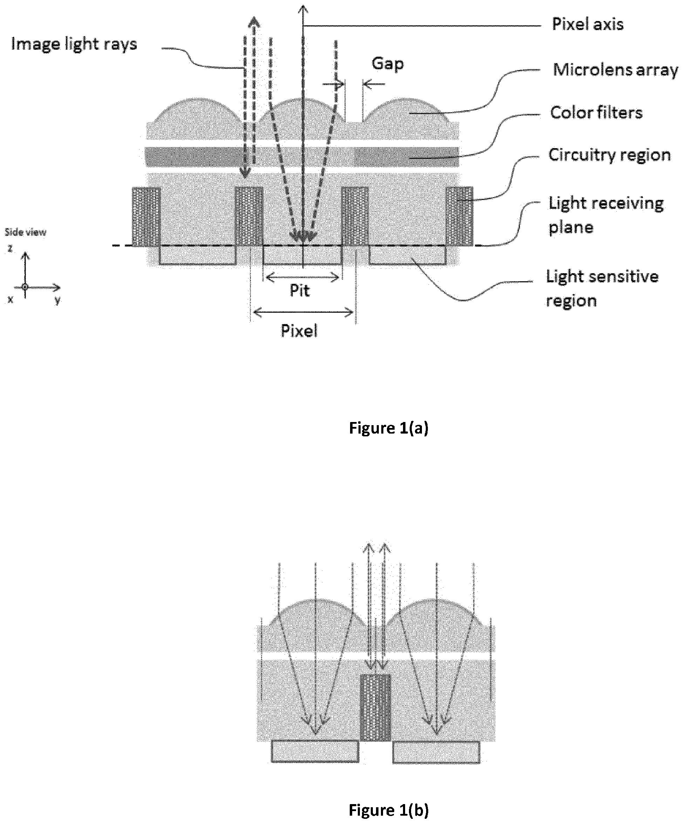

**Figure 1(a)** presents a cross section of three pixels (comprised in a CMOS image sensor covered by microlenses) where said three pixels have a FSI structure.

More precisely, each microlens covers a pixel in order to focus/concentrate the incoming light in direction to the light sensitive region. Hence, as depicted in **Figure 1(a)** and in **Figure 1(b)** a loss of light can occur. Indeed, the incoming light rays that fall between two neighboring microlenses are reflected by the circuitry region of pixels, and are therefore not collected by the light sensitive regions of pixels.

According to one embodiment of the disclosure, it is proposed to use, in an image sensor, a nanojet focusing element comprising elements and/or structures being able to generate nanojet beams as explained in the following. In one embodiment of the disclosure, these elements or structures correspond to nanojet-based focusing components.

According to one embodiment of the disclosure, it appears that diffraction of a plane electromagnetic wave on a dielectric object having an abrupt change level of its surface, also called a step, can result in the formation of condensed optical beams (so-called nanojets), that occur in a vicinity to the step, and are oriented towards the medium with higher refractive index value. The number of beams and shape of each individual beam can be controlled by the variation of the step size and shape of the step edge line, whereas the beam radiation angle and the field intensity enhancement in each individual beam can be controlled by the variation of the refraction index ratio at the boundary of the object in the vicinity of the step and the step base angle.

Unlike the well-known diffractive lenses whose focusing ability is predicted by the Fresnel theory, the nanojet beams are *low-dispersive* (they show a small wavelength dependence). Moreover, the nanojet focusing component (or light guiding means) according to the present disclosure can produce multiple *independent* beams (having identical or non-identical shape), which is not possible with Fresnel diffractive lenses. These unique features make the nanojet-based focusing component (or device) according to the present disclosure attractive for guiding light within an image sensor.

Indeed, according to one embodiment of the disclosure, it is proposed to use light guiding means made up of a dielectric layer and comprising structures (for example either cavities or steps) as detailed in the following.

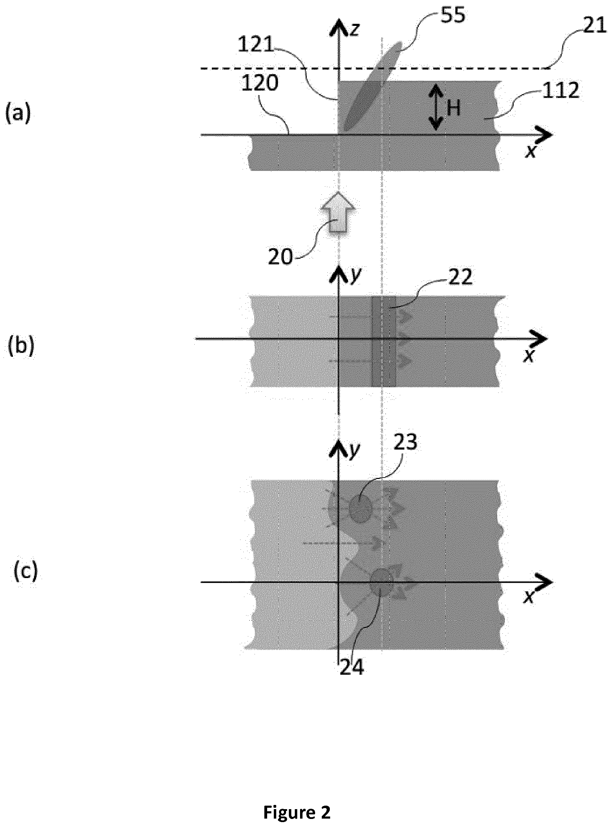

**Figures 2 to 8** allow understanding the physical phenomena explaining the formation of nanojet beams according to the present disclosure.

**Figure 2** illustrates a technique, where an abrupt change occurs in the level of the surface of a dielectric layer 112, thus forming a step in the layer. **Figure 2(a)** shows a side view of the dielectric layer 112. **Figures 2(b) and 2(c)** respectively show top views in case of a step with a straight (**figure 2(b)**) and curved (**figure 2(c)**) edge lines.

As shown in **figure 2(a)**, the device is illuminated by a plane wave 20, incident on the device from below along z-axis with a propagation vector being orthogonal to the base surface of the dielectric layer 112. As schematically shown by the dashed arrows in **figures 2(b) and 2(c)**, a nanojet beam 55 originates from the base edge of the step, which comprises a horizontal part 120 and a lateral part 121 (which may also be tilted with respect to the z-axis forming an arbitrary base angle).

Spots referenced 22 to 24 indicate the corresponding hot spots in the field intensity distribution in the near zone formed in the imaging plane 21. The specific field intensity distribution with two hot spots 23, 24 observed in **figure 2(c)** is associated with the shape of the step edge line having two concave segments responsible for the formation of the two independent nanojet beams.

It should be noted that the boundary curvature of the cavity is a tool for changing the nanojet beam shape, position and field intensity enhancement level.

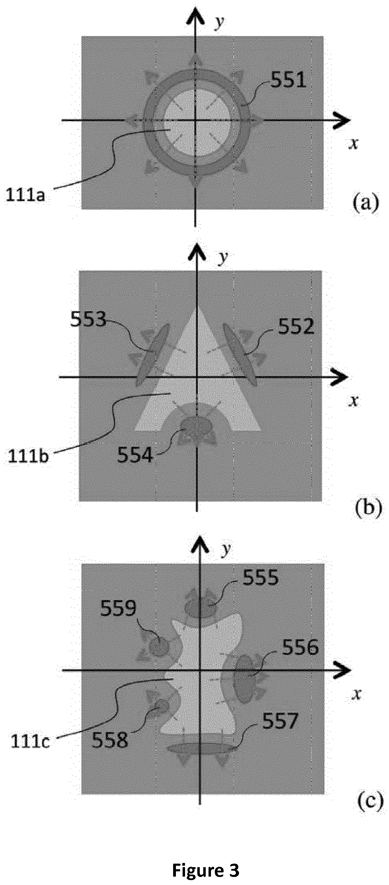

**Figure 3**, which presents a schematic drawing of the field intensity distribution in the imaging plane 21 for three exemplary cylindrical cavities with different cross-sections. More precisely, **figure 3(a)** shows a cavity 111a with a circular cross-section: the dashed arrows schematically show that nanojet beams originate from the base edge of this cavity 111 a. The ring 551 indicates the hot spot in the field intensity distribution in the near zone formed due to the nanojet beams associated with different segments of the circular base edge line.

**Figure 3(b)** shows a non-rotation-symmetric cavity 111 b, whose cross-section in xy-plane is somehow triangular, but with one of the three edges of the triangle which is concave. Such a circa triangular cavity 111 b creates three spots 552, 553 and 554, one of which (554) is enhanced, thanks to the concave edge.

**Figure 3(c)** shows a cavity, which is arbitrary-shaped with five straight or concave segments. Spots 555 to 559 indicate the hot spots in the near-field distribution formed due to the nanojet beams originating from the base edge of the step, as schematically shown by the dashed arrows. The specific field distribution with five hot spots observed in **figure 3(c)** is linked to the specific shape of the edge line having five straight or concave segments responsible for the formation of five independent nanojet beams.

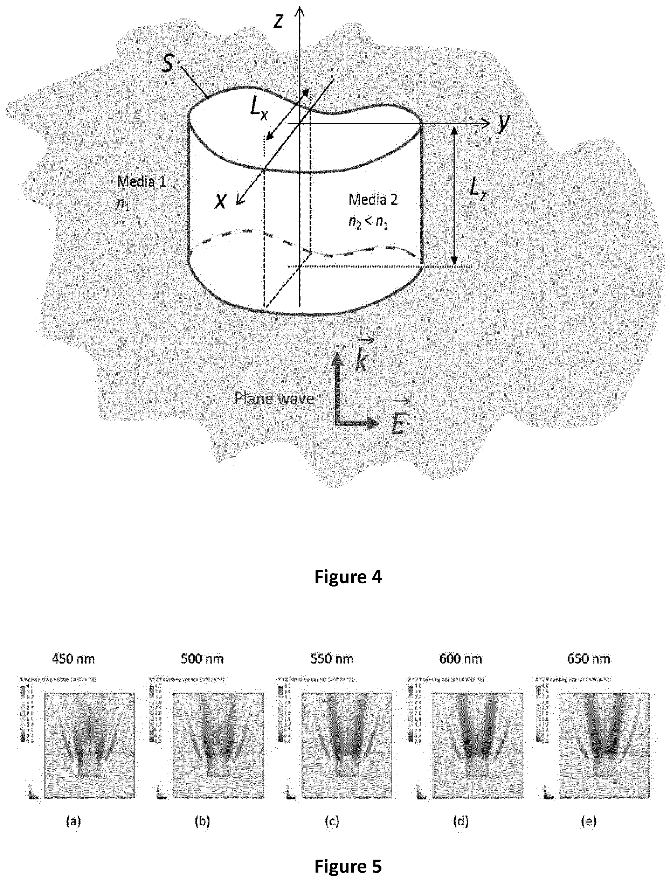

**Figure 4** illustrates an embodiment of the present disclosure, according to which the step formed at the surface of a layer of dielectric material is in fact the edge of a cavity 111 made in the layer of dielectric material 112. The present disclosure is of course not limited to such an embodiment, and any abrupt change of level at the surface of the dielectric material is sufficient for generating the physical phenomenon, which will be described hereafter. Such a step can indeed be considered as the edge of a cavity of infinite size.

It must be understood that, in case of a cavity, the focusing function is to be associated not with the entire structure, but with an elementary segment of the step discontinuity, that can be approximated by a concave (or convex) line having a length of about one half to several wavelengths. The other segments of the step discontinuity will contribute to the formation of the same or other nanojet beams that may form all together (i) a wide uniform "blade like" nanojet beam as in case of an infinite step (**figure 2b**)), or (ii) a spot or ring in case of an arbitrary-large circular cylindrical cavity (**figure 3(a)**), or (iii) an arbitrary number of localized beams of different shapes produced by a curvilinear edge of an arbitrary-shaped cavity (**figures 3(b) and 3(c)**).

For sake of simplicity, we therefore focus hereafter on the example of a cavity 111 formed in the layer of dielectric material 112, like the one illustrated in **figure 4**.

As may be observed, such a cavity is cylindrical, with a cross-section of arbitrary shape. By cylindrical cavity, it is meant here, and throughout this document, a cavity which shape is a cylinder, i.e. a surface created by projecting a closed two-dimensional curve along an axis intersecting the plane of the curve. In other words, such a cylinder is not limited to a right circular cylinder but covers any type of cylinder, notably, but not exclusively, a cuboid or a prism for example.

The cavity may also have the form of a cone. Its main axis may be orthogonal to the surface of the bottom of the cavity, or be tilted. Due to the fabrication tolerance, the cavities may also have imperfect shapes, and it must be understood, for example, that cavities targeted to be shaped as cylinders, may become cone-shaped cavities with S-shape cross-sections during the manufacturing process.

More generally, such cavities are formed as cylinders or cones with an arbitrary cross-section, which can be adapted (optimized) in order to produce a desired near-field pattern, i.e. a desired field intensity distribution in the xy-plane (typically orthogonal to the incident wave propagation direction). This pattern may have one or multiple hot spots with identical (or different) field intensity level.

Non-symmetric cavities are also possible. For example, a cavity which cross-section in the xy-plane is triangular will create three spots. One of them can be enhanced if the corresponding face is concave, as will be explained in greater detail in relation to the figures.

**Figure 4** gives some notations, which will be used hereafter in the document. As may be observed, the cavity is immersed in a host medium *Media 1* noted 112 of refractive index $n_1$, and is filled with a material (air, gas, dielectric, polymer material...) *Media* 2 of refractive index $n_2$, such that $n_2 < n_1$.

For example, the cavity can have a form of a circular cylinder filled in with vacuum ($n_2$ = 1) and embedded in a homogeneous non-dispersive dielectric medium with an example refractive index $n_1$ = 1.49 and illuminated by a linearly-polarized unit-amplitude plane wave $E_y$ = 1 (V/m) propagating in the positive z-axis direction (see **figure 4** for notations).

**Figure 5** illustrates the formation of a nanojet beam by such a cavity when illuminated by this plane wave. More precisely, **figures 5(a) to 5(e)** each correspond to a different wavelength of the incident electromagnetic wave, namely $\lambda_0$ = 450, 500, 550, 600 and 650 nm, and show near-field maps in the XZ-plane plotted in terms of the power density characterized by the time average Poynting vector defined as:

$$P = E_m^2/2\eta \approx 1.3\, n\, E_m^2 \quad [\tfrac{mW}{m^2}], \qquad\qquad \text{(equation 1)}$$

where $E_m$ is the amplitude of the E-field, $\eta$ is the wave impedance in a host medium and n is the host medium refractive index. Note that according to **equation (1)**, the power density value associated with a unit-amplitude plane wave propagating in a dielectric host medium with a refractive index n is equal $P_0 \approx 1.3n\,[\tfrac{mW}{m^2}].$ Hereafter, this value is considered as a reference for the definition of the relative field intensity enhancement (FIE) achieved using different types of nanojet elements embedded in the corresponding host media:

$$FIE = P/P_0\ [a.u.] \qquad\qquad \text{(equation 2)}$$

where P is the simulated power density characterized by the time average Poynting vector and $P_0$ is the reference power density of the unit-amplitude plane wave propagating in the same host medium.

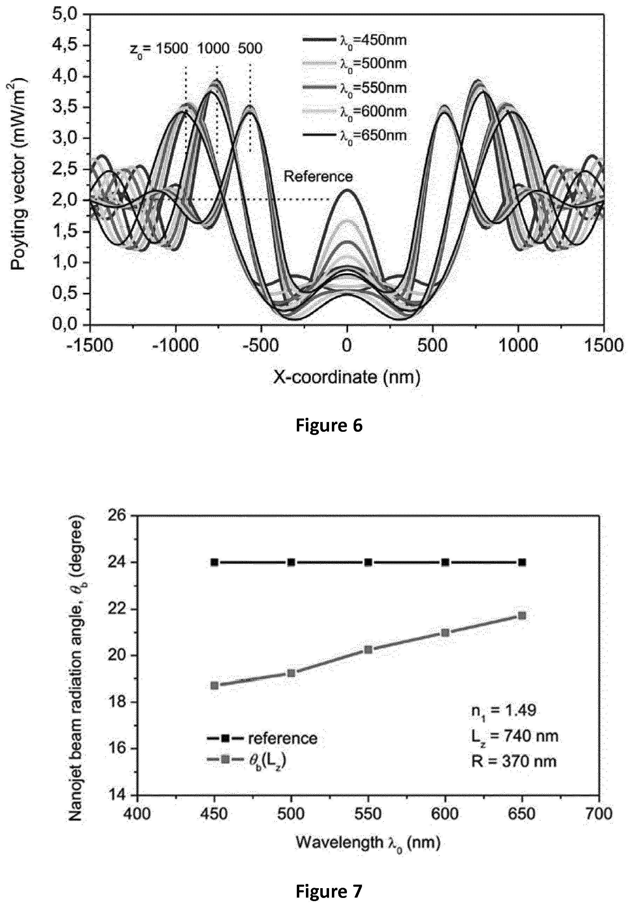

As may be observed in **figure 5**, the shape of the nanojet beam and its direction remain stable in a wide wavelength range. The detailed analysis of the nanojet beam radiation angle is reported in **Figures 6 and 7. Figure 6** illustrates the Poynting vector in the XZ-plane at three different planes defined as $z = z_0 - L_z$, for the five different wavelengths of **figure 5. Figure 7** illustrates the nanojet beam radiation angle calculated based on the positions of maxima in **figure 6** as a function of wavelength.

These data extracted from near-field maps reveal that the variation of the nanojet beam radiation angle does not exceed 3° for the wavelength range from at least 450 to 750 nm. As it is seen in **figure 6**, the major contribution to the angle variation comes from the beam tilt above the cylinder ($z_0$ = 1500nm, where $z_0$ is a relative position of the imaging plane defined with respect to the cavity bottom, i.e. $z_0 = z + L_z$), whereas the beam shape (at $z_0$ = 500nm) remains stable for the entire wavelength range. Such a behavior is not typical for Fresnel-type diffractive lenses and thus requires detailed explanations.

The origins of the nanojet beams can be explained by the combination of three electromagnetic phenomena, which occur in the vicinity of the base edge of the hollow cavity (or more generally in the vicinity of the abrupt change of level in the surface of the dielectric material), namely:

- diffraction from the index-step discontinuity associated with the base 120 of the cavity (or, more generally with the surface of lower level of a step formed in the host medium),
- refraction of the diffracted wave at the vertical edge 121 of the cavity (or more generally on the lateral surface of the step), and
- interference of the refracted wave and the incident plane wave outside the cavity (or more generally in the host medium).

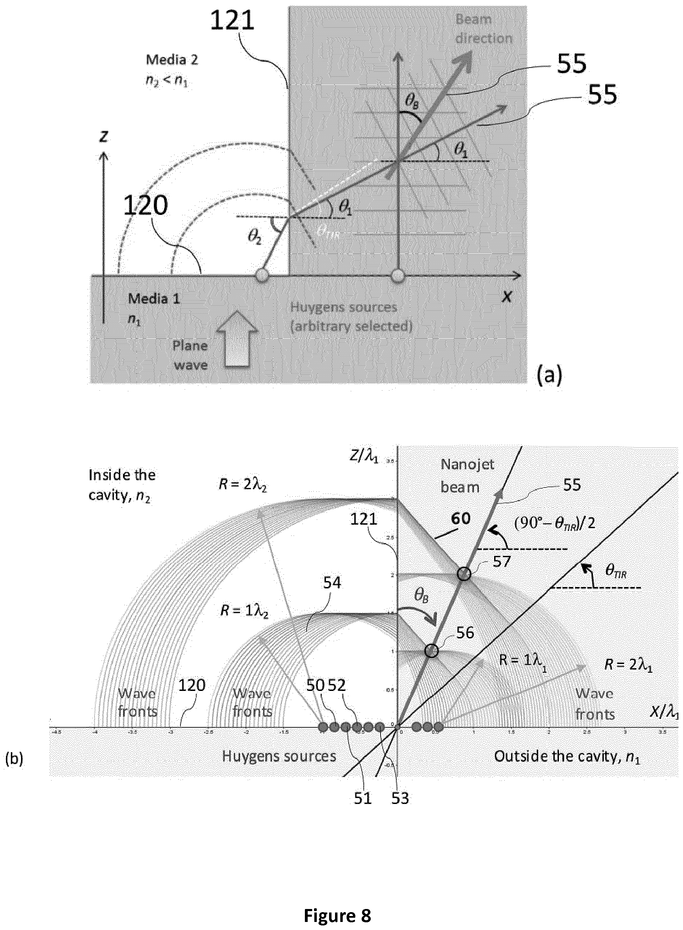

A schematic drawing illustrating these three phenomena is given in **Figure 8.** As in **Figures 5, 6 and 7,** we assume that host media is an optically-transparent non-dispersive dielectric material with a refractive index $n_1$ = 1.49 (e.g. plastic or glass) and the cavity is filled with vacuum or air, $n_2$ = 1. The incident plane wave arrives from below in the diagram.

The key elements of the complex electromagnetic phenomena illustrated in **Figures 8(a) and 8(b)** are the following:

- The incident plane wave induces equivalent currents at the dielectric-air boundary 120 associated with the cavity base (or more generally when reaching the step of index in the host medium induced by the abrupt change of level in its surface);
- These induced currents are considered as Huygens secondary sources 50 to 53;
- In line with the diffraction theory, the spherical waves 54 radiated by the Huygens sources cause some power leakage towards the 'shadow region', i.e. beyond the lateral boundary 121 of the cavity;
- While crossing the lateral (vertical) boundary, the waves radiated by the Huygens sources experience refraction that causes a tilt of the refracted wave on a certain angle in accordance with the Snell-Descartes's law.
- In **Figure 8(b)**, we can notice that outside the cavity the wave fronts coincide for different Huygens source positions along the cavity base line, thus creating a local field enhancement. The planar shape of these fronts evidences for the creation of a directive beam propagating out of the cavity.
- Finally, outside the cavity the refracted wave is constructively interfering 56, 57 with the plane wave incident from below giving rise to the nanojet beam 55.

The nanojet beam creation is hence explained by phenomena that are low-dispersive in their nature, namely (i) edge diffraction, (ii) refraction of the wave at the interface of two dielectric media, and (iii) interference. This explains why the shape of the beam and its radiation angle remain stable versus wavelength, as may be observed in **Figures 5(a) to 5(e)**.

Moreover, the nanojet beam radiation angle is defined by the Snell's law and, thus, is only a function of two parameters:

- ratio between the refraction indexes of the host media and cavity materials, and
- the base angle of the cavity. For sake of simplicity, in the foregoing, we only consider a cavity with the base angle equal 90° thus having a cylindrical shape with vertical edges.

Last, the nanojet beam-forming phenomenon is associated with the edge (not a full aperture) of the cavity and occurs in the 2-D vertical plane orthogonal to the cavity cross-section (see **figure 4** for notations).

As follows from **Figure 8(b)**, the main contribution to the formation of the planar wave front of the refracted wave outside the cavity comes from the Huygens sources 50-53 located close to the lateral edge 121 of the cavity. Because of this, the refraction angle of the wave radiated outward the cavity is close to the critical angle for the wave incident on the same boundary from outside (**Figure 8(a)**):

$$\theta_1 \approx \theta_{TIR} \qquad\qquad \text{(equation 3)}$$

where $\theta_{TIR} = sin^{-1}(n_2/n_1)$ is the critical angle for a diopter with indices $n_1$ and $n_2$.

The nanojet beam 55 is finally created as a result of the interference between the refracted wave and the plane wave incident from below. Thus, the angle of radiation of the nanojet beam ($\theta_B$) is defined by a vector sum of the two waves as schematically shown in **Figure 8(a)**. These considerations lead one to the following approximate formula for the radiation angle of the nanojet beam:

$$\theta_B \approx \left(\frac{\pi}{2} - \theta_{TIR}\right)/2 \qquad\qquad \text{(equation 4)}$$

According to equation (4), in the case of a host medium with index $n_1$ = 1.49 ($\theta_{TIR}$ = 41.8°), the nanojet beam radiation angle should be $\theta_B \sim$ 24° that is slightly larger than observed in the full-wave simulations (see **Figure 7**). This difference is explained by the assumptions made in the qualitative analysis. First, this analysis does not take into account the difference in the amplitude of the diffracted/refracted wave and the incident plane waves. Second, it does not take into account the rays launched by the Huygens sources located close to the cavity edge from outside that experience the total internal reflection on the cavity lateral edge. Being totally reflected, these rays also contribute to the formation of nanojet beam. Note that these two effects are related to the total internal reflection phenomenon and thus cannot be accurately characterized using Snell/Fresnel model. Nevertheless, these both effects (i) depend on the ratio of refraction indexes of the two media and (ii) result in reducing the nanojet radiation angle. Thus, the actual nanojet radiation angle can be smaller than that predicted by equation (4).

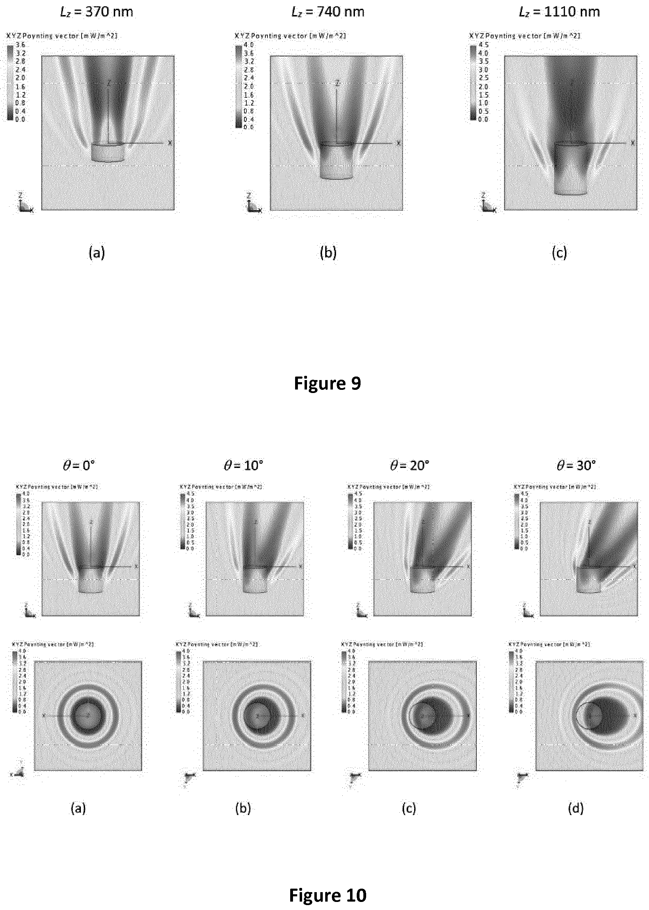

**Figures 9(a) to 9(c)** illustrate near-field maps of the nanojet beam produced by cylindrical cavities ( $n_1$ = 1.49, $n_2$ = 1, $R$=370 nm) of different heights ((a) $H=L_z$=370 nm, (b) $H=L_z$=740 nm, (c) $H=L_z$=1110 nm) when illuminated by a unit-amplitude plane wave from below. As may be observed, the nanojet phenomenon is well pronounced for the cavity size varying from about one to a few wavelengths in the host medium, e.g. $\frac{1}{2} \lambda_1 < L_z < 3 \lambda_1$.

The minimum height is needed to form the planar wave front 60 illustrated in **Figure 8(b)** that gives rise to the nanojet beam. However, the height of the cavity (or the height of the step) should not be too large as compared to the length of the nanojet beam, in order for it to be useful outside the focusing component or device.

As shown on **figures 9(a) to 9(c)**, the length of the nanojet beam can vary from a few to several wavelengths in the host medium depending on the cavity shape and size.

Based on the 2-D ray-tracing analysis of **Figure 8(b)**, the main contribution in the formation of the nanojet beam comes from the feeds located close to the cavity lateral surface (or to the lateral part of the step). The corresponding 'effective aperture' responsible for the formation of the nanojet beam is estimated as about one half of the wavelength in the medium inside the cavity ($\frac{1}{2} \lambda_2$) that is to be counted from the lateral edge inward the cavity. For the cavity having arbitrary shape, this aperture is to be defined along the line orthogonal to the cavity edge line, S in a plane orthogonal to the incident wave propagation direction (see **Figure 4**).

In 2-D case (which may correspond to any vertical cross-section, e.g. in xz-plane), the local field intensity enhancement (FIE) achieved thanks to the nanojet beam formation is about a factor of 2 compared to the incident plane wave (see formula (2) for the definition). A larger FIE can be achieved by modifying the shape of the cavity cross-section and, in particular, the shape of the cavity edge line $S$, as will be explained hereafter in greater details.

The nanojet beam width at half power (BWHP) can vary from about $\frac{1}{2} \lambda_1$ (that is order of the diffraction limit) to several wavelengths and more depending on the shape of the cavity.

**Figures 10(a) to 10(d)** show nanojet beams produced by a hollow cylindrical cavity ($n_1$ = 1.49, $n_2$ = 1, $L_z$=740 nm, R=370 nm) under different angles of incidence of the unit-amplitude plane wave in XZ-plane, namely $\theta$ = 0° in **figure 10(a)**, $\theta$ = 10° in **figure 10(b)**, $\theta$ = 20° in **figure 10(c)** and $\theta$ = 30° in **figure 10(d)**.

The symmetry of the near-field patterns in the XY-plane (see **figure 10(a)**) evidences that the beam shape and radiation angle remain nearly constant for both TE (Transverse Electric) and TM (Transverse Magnetic) polarizations of the incident wave.

Moreover, in case of an incline incidence, it may be observed in **figure 10** that the beam radiation angle changes in correspondence to the angle of incidence of the plane wave. The shape of the beam and field intensity enhancement remain nearly constant for incidence angle up to about $\theta_B$.

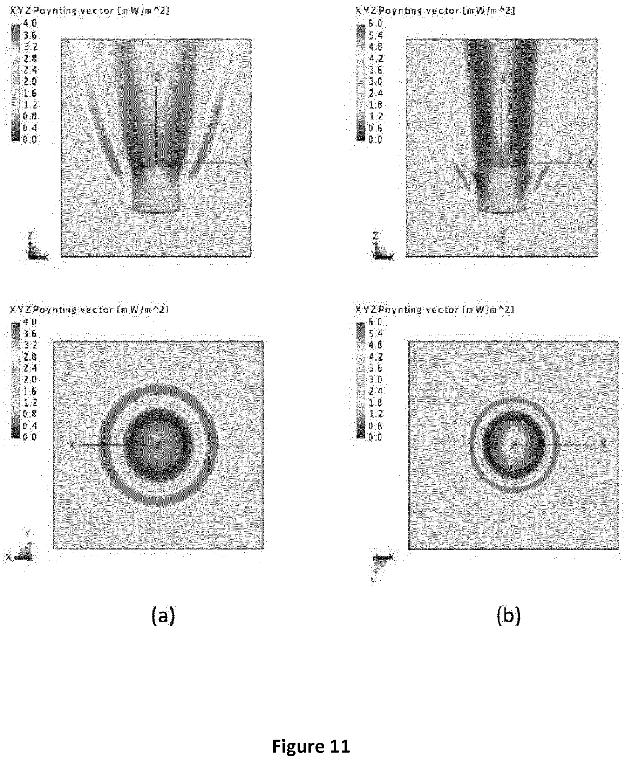

**Figure 11** illustrates the nanojet beams phenomenon as observed for different host media, including standard optical plastics and standard or doped glass. Such nanojet beams are produced by a hollow circular cylindrical cavity having the same physical dimensions ($n_2$ = 1, $L_z$=740 nm, R=370 nm) but embedded in a host medium of refractive index $n_1$ = 1.49, in **figure 11 (a)** and $n_1$ = 2.0, in **figure 11 (b)**.

The understanding of the nanojet formation phenomena illustrated through **figures 2 to 11** allows designing various devices, which can be used as focusing components, beam-forming components, or more generally components (or device) for forming any desired field intensity distribution in the near zone. Such components may be used for transforming an incident plane wave into one or multiple independent beams, or, conversely, for transforming an incident wave beam (whatever its wavelength) into a locally plane wave, in accordance with the symmetrical path properties of electromagnetic waves.

As explained above in the present disclosure, the formation of the nanojet beams is associated with the lateral part of the step in the layer of dielectric material, or with the lateral edge of the cavity, but not its full aperture. By optimizing the shape of the cross-section of the cavity S, it is possible to control the shape of the nanojet beam(s) produced by this cavity.

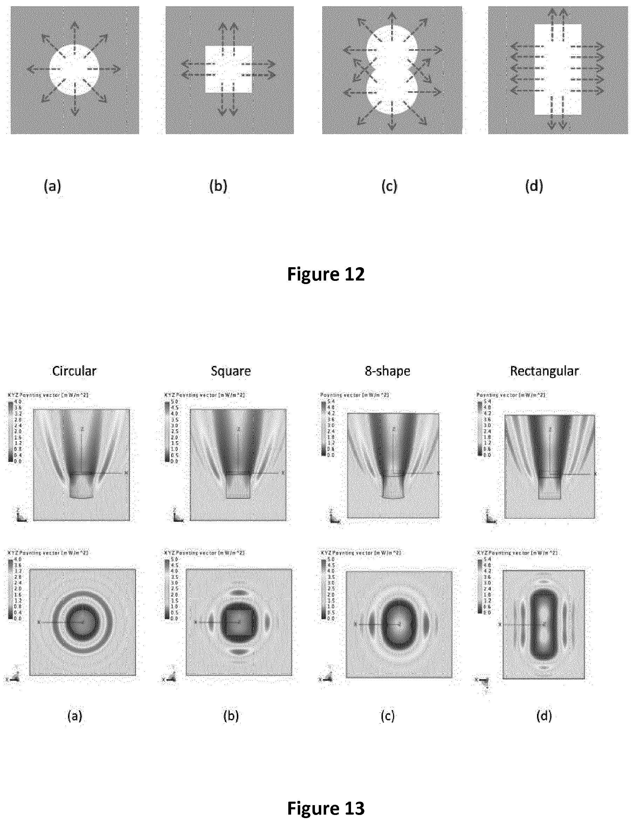

**Figure 12** shows four exemplary cylindrical cavities having each a different shape of the cross-section boundary, namely: **(a)** circular, **(b)** square, **(c)** 8-shape, and **(d)** rectangular. The dashed arrows schematically show some vertical cut planes and directions of the generated nanojet beams when these cavities are illuminated by a plane wave propagating along z-axis, from the plane of the figures. These cut planes are defined with respect to the direction of the normal vectors defined at the corresponding points of the cavity cross-section boundary. The corresponding simulated near-field maps for each cavity are shown in **Figures 13(a) to 13(d)**, which illustrate the power density distribution in xz-plane (y=0) and xy-plane (z= $z_0$) for hollow cavities, having same height and radius but different cross-section shapes ($L_z$ = $L_x$ = 2R = 740nm), illuminated by a unit-amplitude plane wave propagation in the positive z-axis direction: **(a)** circular, **(b)** square, **(c)** 8-shape, **(d)** rectangular. The spots 101 to 104 in the xy-plane identify the nanojet beams, whose shapes and positions are well in line with the predictions given in **figure 13** (these near-field maps are computed at arbitrary-selected xy-plane , defined with respect to the cavity base plane).

In particular, **Figure 13(a)** shows that the axially-symmetrical circular cavity produces a diverging conical beam, whose cross-sections in the vertical (xz) and horizontal (xy) planes are shown in **Figure 13(a)** top and bottom figures, respectively. It is interesting to note that this conical beam is nearly-symmetrical (see the near-field pattern in horizontal xy-plane), which is an evidence for the polarization-insensitive behavior of such component (or device). The field intensity enhancement observed in this configuration is a factor of two, i.e. FIE $\approx$ 2 a.u. (defined in accordance with equation 2).

**Figures 13(b) and 13(c)** show how the transformation of the cavity cross-section, S, from the circular shape to rectangular and 8-shape causes the formation of multi-beam near-field patterns with four (referenced 104) and two (referenced 103) nanojet beams, respectively. This beam-forming effect is related to the transformation of the boundary segments from a convex shape to a planar shape and then to concave shape, respectively. The beams observed in **Figure 13(b) and 13(c)** have a radiation angle similar to the one of the conical beam produced by the circular cylinder (**Figure 13(a)**). At the same time, the width of the beams in terms of the azimuth angle is different. The larger the internal angle of the concave segment of the cavity cross-section boundary, S, the narrower the beam and the higher the field intensity. In particular, the FIE for the two cavities presented in **Figure 13(b)** (square shape) and **13(c)** (rectangular shape) is equal to -2.5 a.u. and -2.8 a.u., respectively.

Finally, **Figure 13(d)** shows a wide blade-like nanojet beam generated by the hollow rectangular cavity. This example demonstrates the possibility to form wide beams that can be of interest for certain applications requiring uniform illumination of narrow shaped areas.

The boundary curvature of the cavity is hence a tool for changing the nanojet beam shape, position and field intensity enhancement.

The same approach can be used to build more complex components with symmetrical or non-symmetrical cross-sections producing an arbitrary number of identical or different nanojet beams, as depicted in **Figure 3**.

However, the nanojet focusing components (or devices) previously described in Figures 2 to 13 have some constrains related to the limited field intensity enhancement and fixed radiation angle of the nanojet beam that need to be improved in order to make the nanojet elements or components (also named nanojet lenses or devices) capable of reproducing the focusing functions of their conventional analogs, such as refractive and diffractive micro elements.

In one embodiment of the disclosure, it is proposed to transform the configuration of the cavity in such a way that all the nanojet beams, originating from different segments of the cavity cross-section boundary, recombine and contribute to the formation of a single high-intensity nanojet beam located on the axis of symmetry of the cavity and oriented along this axis, i.e. with no tilt compared to the incident plane wave.

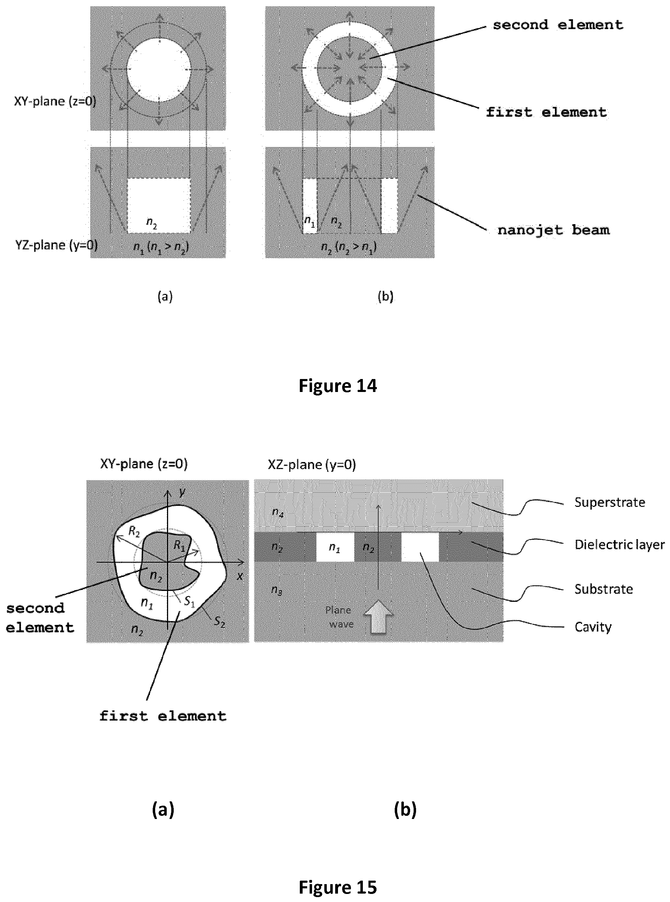

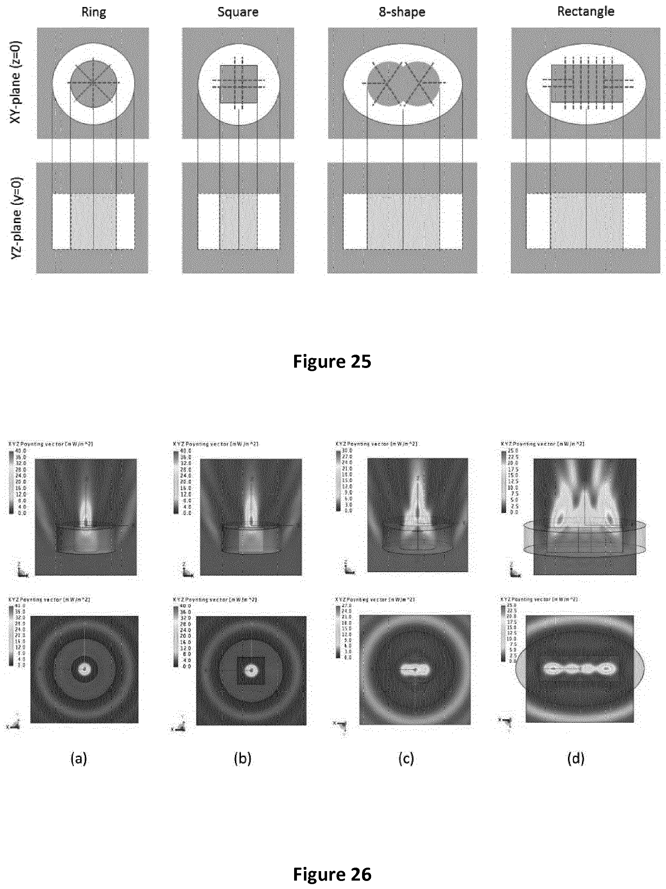

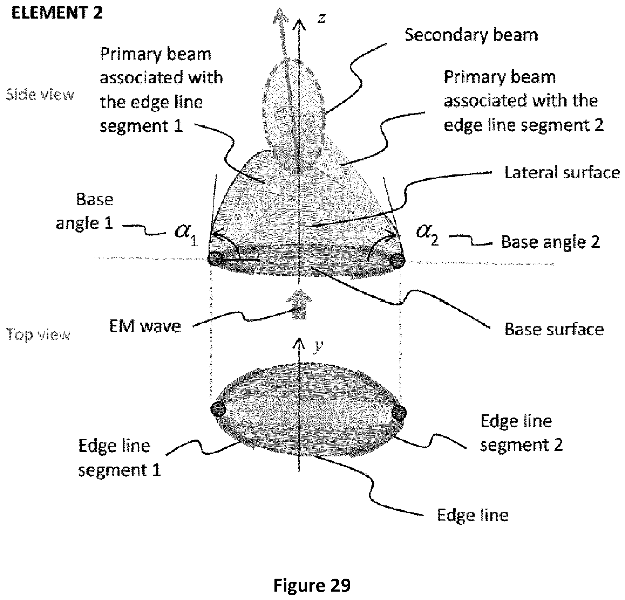

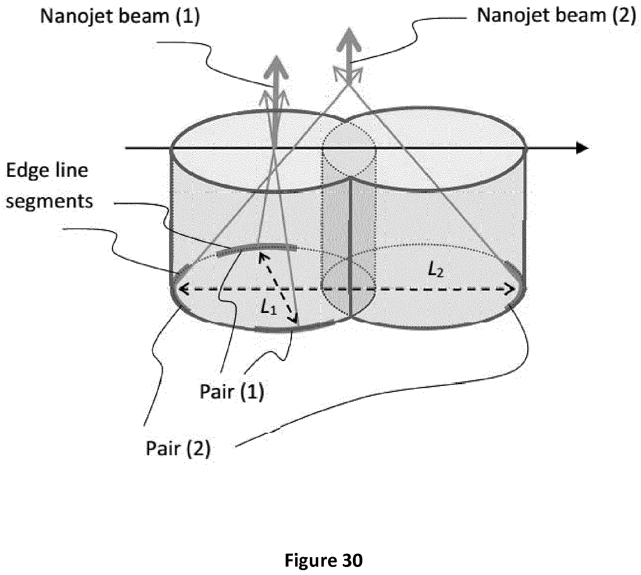

In order to achieve this, it is proposed to use a device comprising at least one layer of a dielectric material comprising at least partially a first element (for example having the shape of a cylinder or a cuboid as depicted in **Figure 14(b))**, such first element having a first refractive index value, such first element comprising at least partially a second element (for example having the shape of a cylinder, or other shapes as depicted in **Figure 25**), such second element having a second refractive index value greater than the first index value, and wherein the second element comprises at least a base surface, defined with respect to an arrival direction of an electromagnetic wave, and wherein the at least a base surface comprises at least two opposite edge line segments (see for example the **Figures 29** and **30**) whose shape (for example the curvature) and associated base angles between the at least a base surface and a lateral surface of the second element, in a vertical plane with respect to said at least a base surface, control a shape of at least one focused beam (see for example the **Figure 29** and **30**).

It should be noted that the intensity of the at least one focused beam is defined by the length of the two corresponding edge line segments of the at least a base surface.

As schematically shown in **Figure 14(b)**, the desired effect can be achieved by exchanging the index values inside and outside the cylinder. The additional advantages of the proposed ring-type structure include the natural solutions of the problems related to setting the element in space (that is a critical drawback of the microspheres) and its possible fabrication using standard optical materials and established planar microfabrication technologies.

A general topology of the ring-type nanojet component is illustrated in **Figures 15 (a) and (b)**. It has a form of a double-layer cylinder with an arbitrary cross-section embedded in a homogeneous non-dispersive dielectric host medium. Hereafter, we assume that the core of the cylinder has refractive index $n_2 > n_1$ and that it is made of a material having the same refractive index as the host media, $n_2 = n_3 = n_4$.

For instance, the host media may have a refractive index similar to the one of glass or plastic in the optical range (e.g. $n_2 = 1.49$) with a ring-type cavity filled in with vacuum or air, $n_1 = 1$.

In principle, the cylinder cross-section boundaries $S_1$ (core cylinder) and $S_2$ (external cylinder) can have any shape (symmetrical or non-symmetrical). The impact of the size and shape of each boundary is investigated later in the description. In one embodiment of the disclosure, the cylindrical structures could be oblique and/or truncated and/or comprise a rounded top surface.

Hereafter, we consider cylindrical structures with vertical edges parallel to z-axis and top/bottom surface parallel to xy-plane. However, as mentioned previously, some conical and prismatic structures with arbitrary base angles can also be used. The variation of the base angles associated with different segments of the base edge line can be used to produce nanojet beams with different radiation angles. This option is not discussed here, but one skilled in the art could handle that question according to the teachings of the present disclosure.

In one of its embodiments, the ring-type nanojet element can be implemented in a form of a double-layer circular cylinder. In the following analysis, we assume that its core is filled in with a material same as the host medium ($n_2 = n_3$ = 1.49 for instance) and the outer shell (the cavity) is filled in with vacuum or air ($n_1 = 1$).

Under the above assumption (i.e. double-layer circular cylindrical shape and pre-selected host medium material), configuration of a ring-type nanojet element is controlled by three parameters, namely: its height along z-axis ($L_z$) and radii of the two cylindrical layers ($R_1$ and $R_2 = R_1 + W$, where $W$ is the width of the ring).

**Focal length**

In a first approximation, the focal length of the ring-type nanojet element can be derived as a function of the core radius, $R_1$ and nanojet beam radiation angle, $\theta_B$, defined by equation (4). Under assumption that the nanojet radiation angle remains constant for any combination of the ring-type element height and radii, the focal length of the ring-type element can be estimated as:

$$F \approx R_1 / \tan(\theta_B), \qquad\qquad\qquad \text{(equation 5)}$$

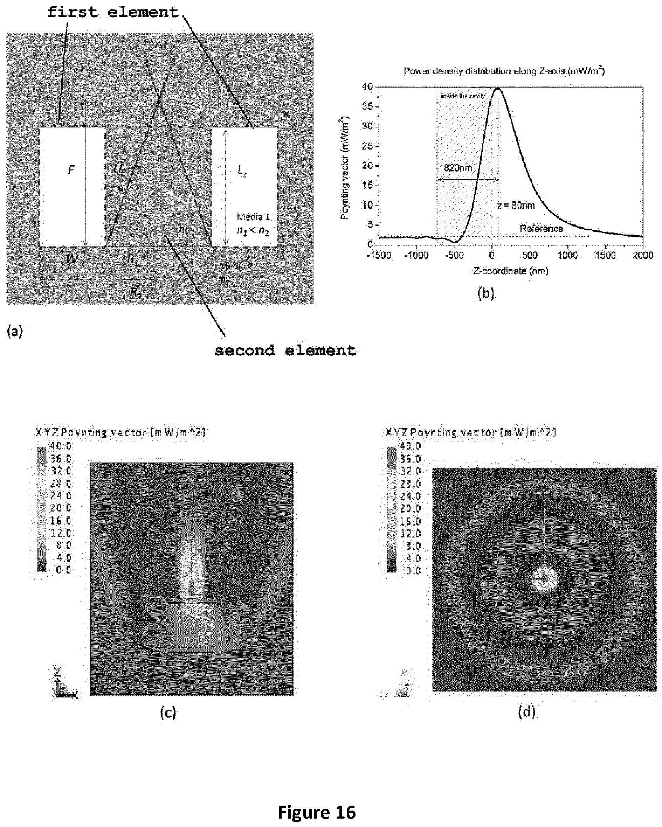

where F is the distance from the element bottom to the point with maximum field intensity **(Figure 16(a))**.

According to equation (5), in case of a hollow ($n_1 = 1$) ring-type nanojet element embedded in a host medium with a refractive index $n_2 = 1.49$, ($\theta_{TIR} \approx 42°$), the focal length is estimated as $F \approx 2.25\,R_1$.

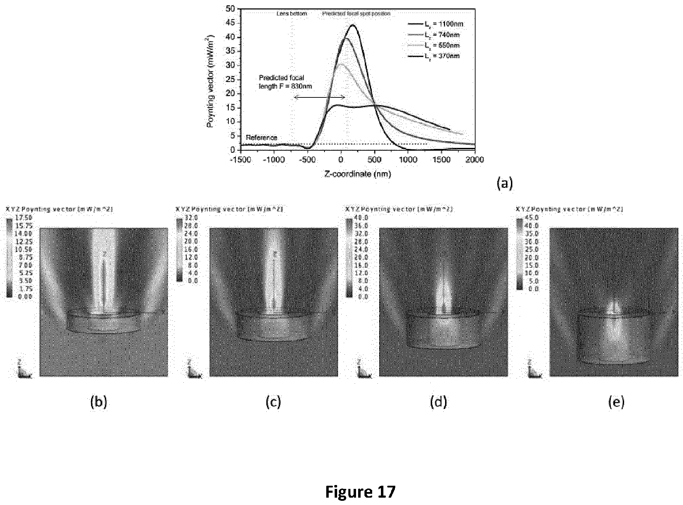

As may be seen in **Figure 17**, the actual value of the focal length (defined based on the position of a point with a maximum field intensity value) and the length of the nanojet beam can vary depending on the size and shape of the ring-type cavity. The family of four curves in **Figure 17(a)** represents the power density distribution along z-axis for the ring-type element having a fixed ring dimensions ($R_1 = 370$nm, $W = 500$nm) but different height along z-axis, defined by parameter $L_z$. For an element with a height smaller (or larger) than the focal length, the hot spot is observed closer (or further) than expected, with the best agreement observed for the element with height close to the focal length $L_z \sim F$. Note that all curves in **Figure 17(a)** are superimposed in such a way that the element base position coincides for all configurations).

The increase of the beam length observed in **Figure 17 (a)** is explained by the interplay between the nanojet and Fresnel-type focusing mechanisms. The contribution of the latter becomes noticeable because of the insufficient height of the cavity, which prevents formation of the nanojet beam (evidenced by a roughly twice smaller value of the peak power density).

**Angle of incidence**

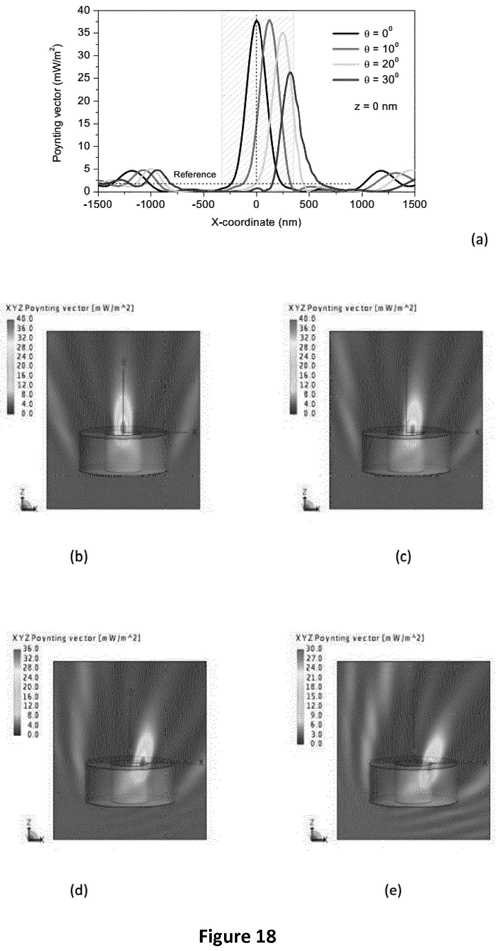

In case of an incline illumination, the nanojet beam angle tilts proportionally to the tilt of the incident wave propagation direction (see the **Figure 18**).

**Ring width, *W***

The width of the ring-type cavity can alter characteristics of the nanojet beam. In particular, it can affect the focal length and beam shape of the ring-type nanojet element.

Although the nanojet beam formation is associated with the base edge of the cavity, there exists a finite-size effective aperture responsible for its formation (see dashed lines in **Figure 14(b)**). This aperture extends to about one half of the wavelength in corresponding media on both sides from the lateral surface of the core cylinder. Thus, a minimum recommended width of the ring-type cavity is estimated as $W \leq \frac{1}{2}\lambda_1$, where $\lambda_1 = k_0/n_1$.

An oversized ring can also affect the nanojet beam formation because of two phenomena associated with the overall size of the ring-type cavity, namely: (i) internal reflections inside the ring-type cavity and (ii) Fresnel-type focusing effect associated with the diffracted waves originating from the top surface of the ring-type cavity. Empirical analysis suggests the upper limit of the width such as $W \approx 3\lambda_1$. For larger rings, the contribution of the ring can become dominant, thus masking the nanojet phenomenon. However, if needed (e.g. for technological needs), the ring width can be enlarged rather arbitrarily without spoiling the nanojet phenomenon **(Figure 19(a))**.

Moreover, for each size (height and radius) of the core cylinder, the size of the ring-type cavity can be optimized in order to:

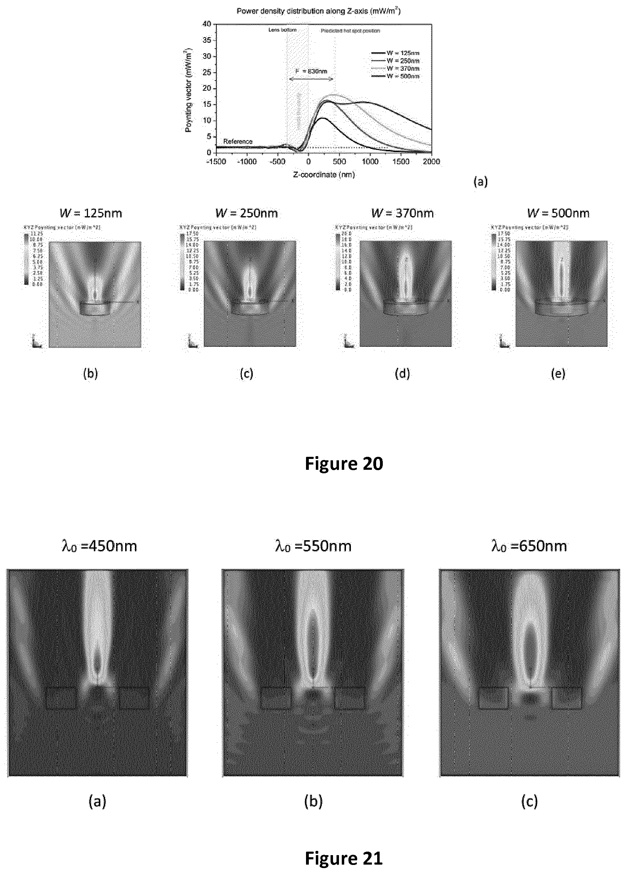

- increase the field intensity in the hot spot **(Figure 19),**
- change the length of the nanojet beam **(Figure 20).**

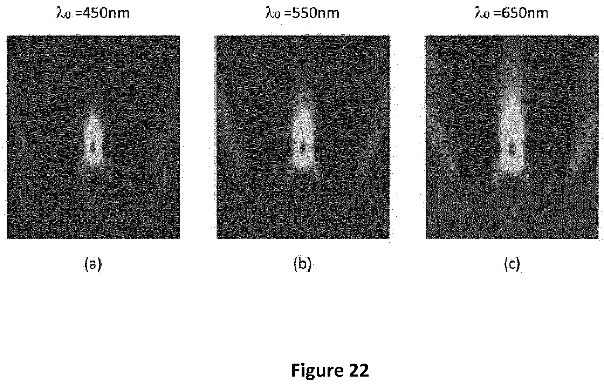

Note that the effects related to the height and width of the ring-type are more narrowband than the nanojet beam phenomenon **(Figures 21 and 22).**

**Field intensity enhancement by combining the nanojet and Fresnel focusing effects**

The impact of the ring width on the maximum field intensity in the hot spot of the ring-type nanojet element is illustrated in **Figure 19.** Here, in **Figure 19 (a),** one can see the power density distribution along z-axis for the element with a fixed core size ($L_z$ = 740nm, $R_1$ = 370nm) and variable width of the ring. For convenience, the maximum values of the power density observed for different width of the ring are plotted in **Figure 19(b)** together with the hot spot position. The corresponding near-field patterns are given in **Figures 19 (c)-(f).** As we can see, the maximum power density of ~ 40mW/m$^2$ is achieved for the ring width $W \approx 500$nm (i.e. about one wavelength inside the cavity). According to **equation (2),** the corresponding field intensity enhancement is FIE≈20 a.u. that is 10 times higher than that observed for the hollow cylindrical cavity 111 reported in **figure 5.**

**Length of the nanojet beam**

The impact of the ring width on the length of the nanojet beam is illustrated in **Figure 20.** Here, a small height of the element prevents effective generation of the nanojet beams that is evident by a much lower field intensity compared to larger size elements reported **Figure 19.** Because of this, the contribution of the Fresnel-type focusing mechanism becomes comparable to the nanojet phenomena. As a result, a longer beam with two maxima along z-axis is created.

**Bandwidth of the nanojet and Fresnel-type beam forming effects**

The difference in the physical mechanisms behind the nanojet and Fresnel-type focusing mechanisms results in a different bandwidth of these two phenomena.
The well-known Fresnel type focusing is based on the interference of the diffracted waves originating from the top surface of the ring cavity. Interference of the waves produced by different segments of the ring top surface can lead to the formation of multiple hot spots and beams corresponding to different diffraction orders. Thus, the radiation direction of these beams, as well as positions of the hot spots, strongly depend on the wavelength of the incident wave. On the opposite, the nanojet beams are created independently at each segment of the cavity base edge line. Because of these, the position and shape of the nanojet beam created on the optical axis of the ring-type element as a result of recombination of nanojet beams produced by different segments of the cavity base edge line, is less sensitive to the incident wave wavelength.
The difference in the dispersive behavior of both types of the focusing mechanisms is illustrated in **Figures 21 and 22.** In **Figure 21,** element dimensions correspond to the case, when its behavior is defined by a superposition of the Fresnel type and nanojet phenomena (this configuration corresponds to the one studied in **Figure 20(e)**). Because of this, a significant variation of the nanojet beam length is observed versus wavelength. On the opposite, in **Figure 22**, element dimensions are selected so that the beam shape is well preserved for the entire wavelength range (this configuration corresponds to the one studied in **Figure 19(d)**). Such a behavior evidences for the dominant role of the nanojet effect in the formation for the beam.

**External ring shape, $S_2$**

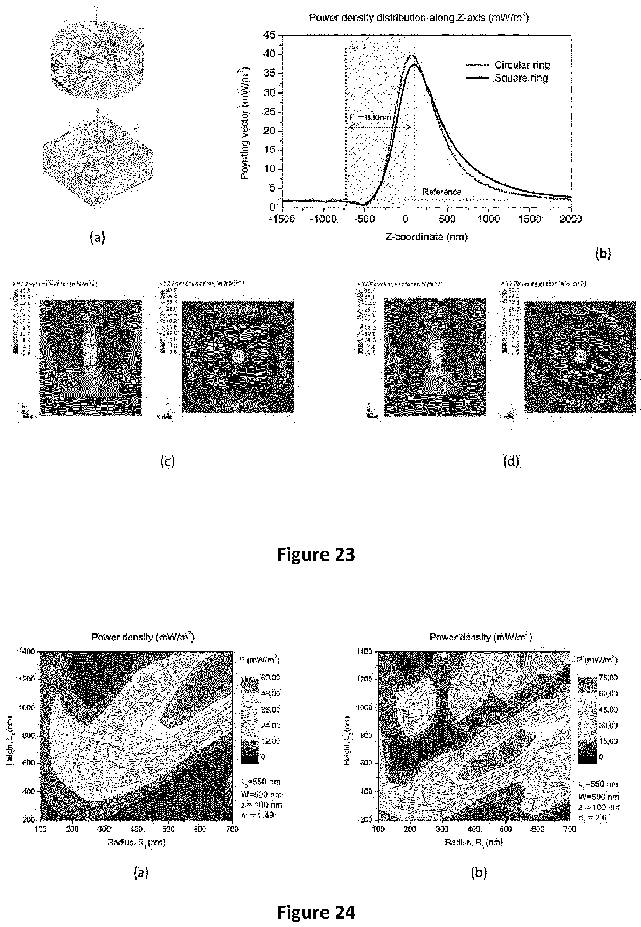

The external shape of the ring can be selected rather arbitrarily.
As we can **see in Figure 23**, the variation of the shape of the ring external boundary of the ring (defined by $S_2$) produces only a minor impact on the nanojet beam. For instance, the transformation of the external cylinder cross-section from circular to rectangular results only in a minor decrease (~10%) of the field intensity in the focal spot, whose position remained nearly unchanged for both configurations.
A larger impact can be expected for certain configurations of ring-type elements, when its performance is defined by an interplay of the Fresnel-type and nanojet phenomena (not shown).

**Core size, $R_1$**

The core size is a key parameter of the ring-type nanojet element. This parameter determines the hot spot position along z-axis and peak field intensity in the nanojet beam region.

The radius of the core cylinder defines the length and curvature of the edge line and thus the total effective aperture of the nanojet element. The longer the edge, the more power is trapped and guided towards the nanojet beam, thus increasing the field intensity in the focal spot. In case when the core, substrate, and superstrate are of the same material ($n_2 = n_3 = n_4$, see **Figure 15** for notations), a linear increase of the field intensity versus the core cylinder radius is observed **(Figure 24)**. In case of a ring-type element structure comprising a stack of several layers of different materials, internal reflections inside the core can appear and alter the nanojet beam formation conditions. The larger the index ratio and the larger the core dimensions, the stronger is a possible impact of internal reflections (i.e. the larger the number of resonant modes that can be supported inside the core cylinder and the higher the quality factors of some of these modes).

**Optimal combination of the element height and radius & impact of the host media material**

The optimal ratio between the core height and radius as well as the estimated FIE due to the nanojet focusing effect, is a function of the index ratio between the element core and cavity materials. The full wave analysis of the ring-type nanojet element with a hollow ring ($n_1 = 1$) embedded in an unbounded host medium with refractive index $n_2 = 1.49$ revealed that maximum field intensity is achieved for $L_z/R_1 \approx 2$ **(Figure 24(a))**. The corresponding field intensity enhancement is estimated as FIE ~ 18 $R_1/\lambda_1$ [a.u.] (valid at least for ½ < $R_1/\lambda_2$ < 2). In case of $n_1 = 2.0$, the optimal ratio is defined as $L_z/R_1 = 1.4$ **(Figure 24(b))**. The corresponding field intensity enhancement is estimated as FIE ~ 16 $R_1/\lambda_1$ [a.u.] (valid at least for ½ < $R_1/\lambda_2$ < 3).

**Core shape, $S_1$**

The shape of the core cylinder can be selected rather arbitrarily and optimized in order to provide a desired shape and size of the nanojet beam **(Figures 25 and 26)**.

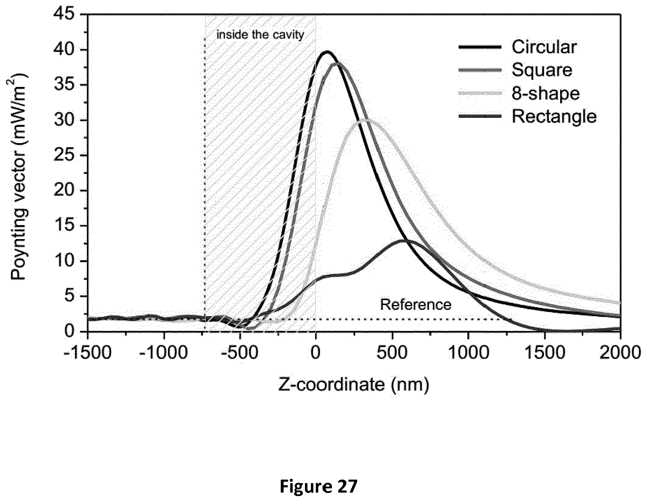

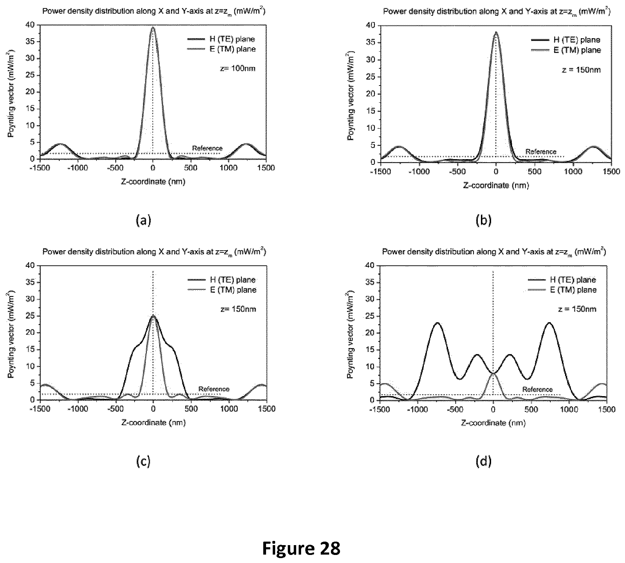

Modification of the core shape of the ring-type nanojet element enables one to modify the partial contributions of the nanojet beams associated with different segments of the core base edge line. A few exemplary embodiments of the ring-type nanojet element with cores of a different shape are illustrated in **Figure 25**. The beams contributing to the formation of the central nanojet beam are shown schematically by dashed lines. The corresponding power density distributions for each configuration are shown in **Figures 26-28**. As we can see in **Figures 26(a) and 26 (b)**, the transformation of the core cylinder cross-section from a circle to square has only a minor (~10%) impact on the maximum value of the power density in the hot spot (best seen in **Figure 27**), whereas the hot spot position and beam symmetry are well preserved for both circular and square configurations **(Figure 28(a) and 28(b))**. As we can see in **Figures 26 (c) and 26 (d)**, the transformation of the circular core into a more complex 8-type and bar-type shapes results in the formation of asymmetric beams, whose shape reproduces the shape of the core. Apart from the nanojet beam width and length, the transformation of the core shape also affects the maximum power density in the hot spot of the nanojet beam **(Figure 27)**. As expected, the maximum value is observed for the circular core (thanks to its symmetry) and the lowest for the element with a bar-type rectangular core. The cross-sectional views of the beams for each configuration are shown in **Figure 28.**

**Figure 29** presents two different views of a second element according to one embodiment of the disclosure.

These views present at least three parameters associated with said second element that can control the shape and the orientation of the focused beam: the length and the curvature of the edge line segment associated with the base surface, and also the values of the base angles associated with opposite edge line segments.

**Figure 30** presents a 3D view of a second element according to one embodiment of the disclosure, representing two pairs of opposite edge line segments contributing to the formation of two independent nanojet beams. In case of $L_1 \approx L_2$, the two nanojet beams can recombine in a single beam having a more complex shape (e.g. see **figure 26(c)**). In case of $L_1 << L_2$, the nanojet beam (2) may appear at a longer distance from the top surface of the element and have a much lower field intensity value than for nanojet beam (1). For instance, such a situation may occur for $L_2 > 5$, where is a wavelength in the host medium (i.e. inside the cavity).

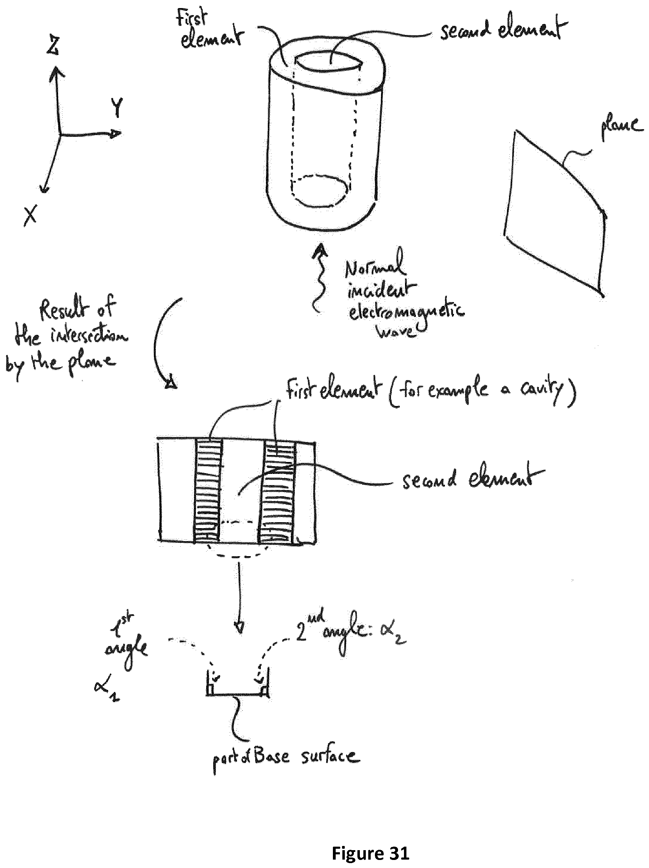

**Figure 31** presents the intersection of a part of the device according to the disclosure by a plane that is parallel to the propagation of an incident electromagnetic wave (and more precisely with a normal incident electromagnetic magnetic wave with regards to the bottom of dielectric layer).

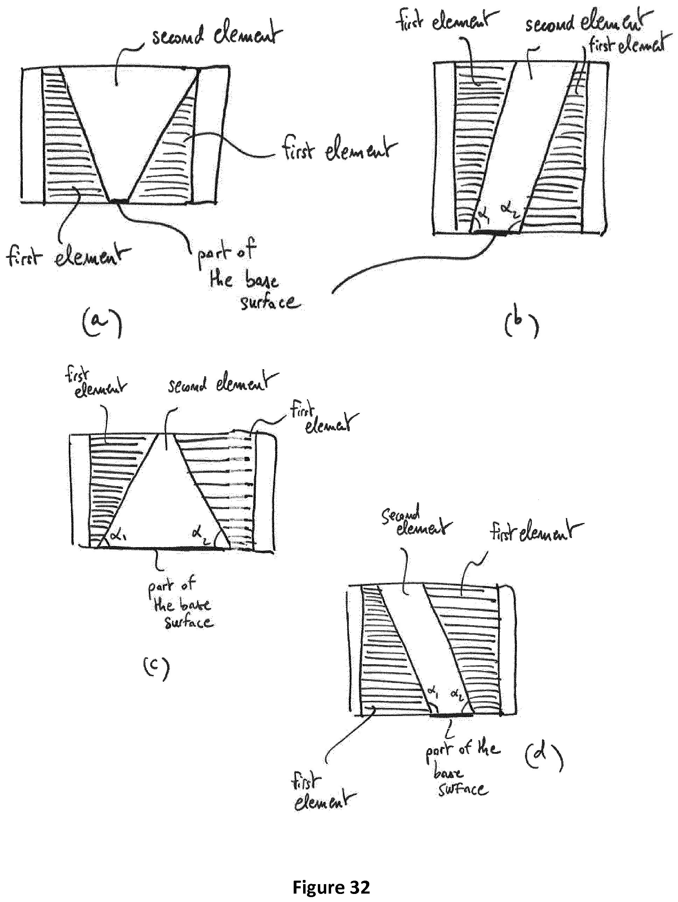

**Figures 32 (a)-(d)**, present different resulting intersections of a part of the device according to the disclosure, by a plane that is parallel to the propagation of an incident electromagnetic wave (and more precisely with a normal incident electromagnetic magnetic wave with regards to the bottom of dielectric layer).

It should be noted that the **nanojet beams** generated thanks to the interference of the two parts of the wave fronts of the incident wave propagating through the base of the first and second elements recombine all together inside the second element giving rise to a **focused nanojet beam.** In case of a normal incidence of the plane wave, for an element having symmetrical cross-section and equal values of the previously mentioned base angles associated with opposite base edge line segments, a symmetrical nanojet beam is created on the optical axis of the element with an orientation along this axis. It should be noted that, in case of an oblique incidence of the plane wave, the beam is tilted proportionally.

One skilled in the art, by varying the shape and size of the first and second elements and, in particular, by varying the shape of the base edge line and associated base angles, could control the shape, position, and radiation angle of the nanojet beam(s). Hence, it is possible to control the focusing and beam forming characteristics of the nanojet focusing device according to selected parameters.

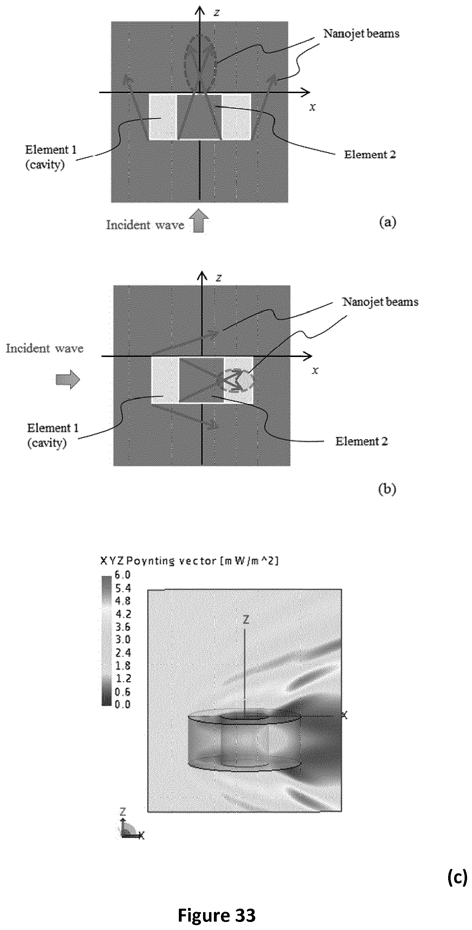

**Figure 33** presents schematic drawings of the nanojet beams produced by a device (or ring-type nanojet element), according to one embodiment of the disclosure, that is illuminated by a plane wave: **(a)** which is incident from below, along z-axis, **(b)** which is incident from left, along x-axis. The arrows from the first element indicate the nanojet beams. **Figure 33(c)** presents the power density distributions in xz-plane when the device according to one embodiment of the disclosure (i.e. comprising the ring structure) is illuminated from the left (along x axis).

It should be noted that in the case the plane wave is incident from left, the at least one base surface of the second element previously mentioned correspond to the lateral surface of a cylinder in the common sense with the at least two edge line segments being parts of the cylinder top and bottom edge lines However, one skilled in the art would understand this change of common sense.

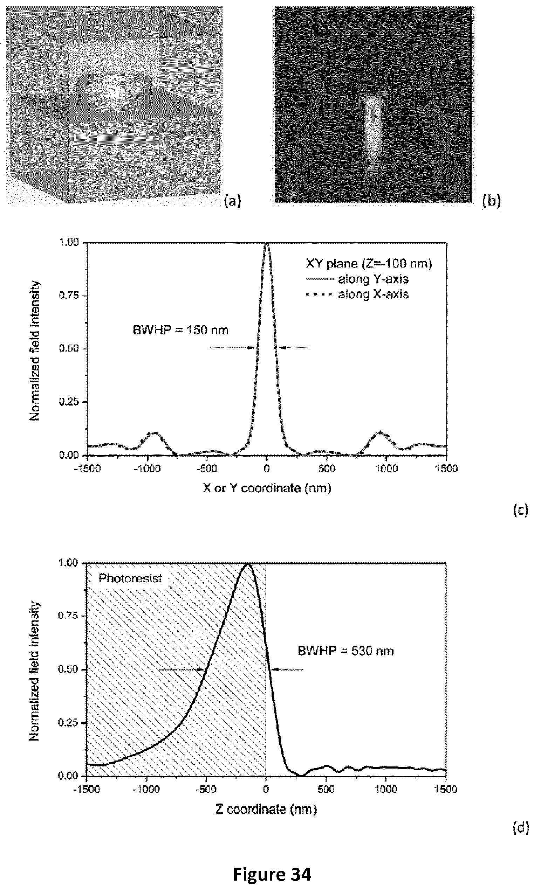

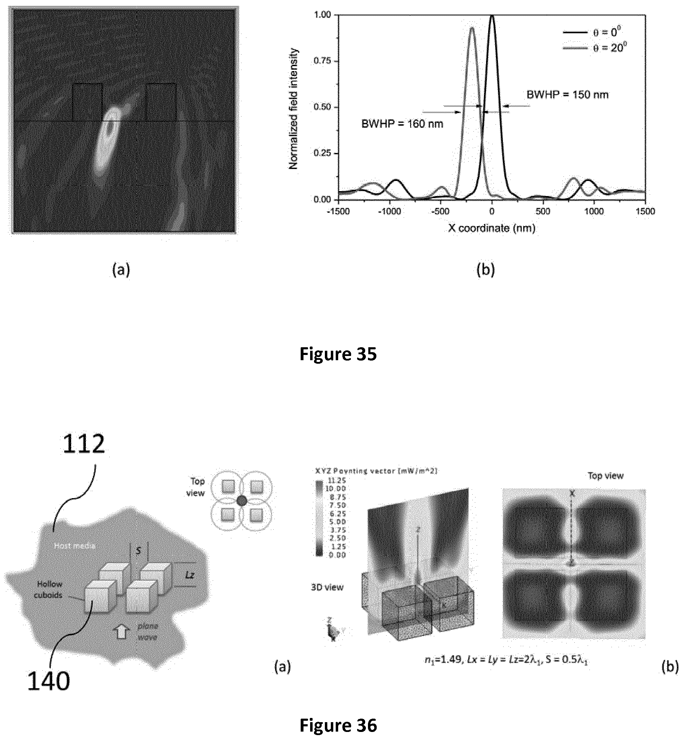

The **figure 34(a)** present a CAD model of a hollow ring-type NJ element having a form of a double-layer circular cylinder (R1 = 300nm, R2 = 700nm, H = 500nm) created in glass plate (n1 = 1.5nm) placed on top of a layer with a higher refractive index (n2 = 1.7), **figure 34(b)** presents a normalized field intensity in YZ-plane when illuminated by a plane wave ($\lambda$ = 365 nm) from above, **figure 34(c)** presents a normalized field intensity distribution along X and Y axes at Z = -100 nm, and **figure 34(d)** presents a normalized field intensity distribution along Z-axis. The **figure 35** presents (a) a normalized field intensity in XZ-plane for the ring-type NJ microlens illuminated by a plane wave ( = 365 nm) with 20° incidence angle defined with respect to the vertical axis, and (b) a normalized field intensity distribution along X-axis at Y = 0 nm, Z = -100 nm for two different incident angles of the plane wave, 0° and 20°. Parameters of the structure are the same as in **Figure 34**.

**Figure 36** illustrates a specific embodiment of the present disclosure, according to which the focusing component is based on a 2x2 array of hollow cuboids embedded in a host medium. **Figure 36a** illustrates the topology of such a component, while **figure 36b** provides simulation results of the time-averaged power distribution when the component is illuminated by a unit-amplitude plane wave propagating along z-axis ($n_1$=1.49, $L_x = L_y = L_z = 2$ $_1$, $S = 0.5$ $_1$).

The component of **figure 36a** comprises four hollow cuboids ($n_2$ = 1) 140 embedded in an optically transparent host medium 112 with refractive index $n_1 > n_2$. For instance, this can be a glass, plastic (e.g. PMMA), or polymer (e.g. PDMS (Polydimethylsiloxane)).

A nanojet beam is generated on the axis of the 2x2 array of hollow ($n_2$=1) cuboids 140 embedded in a homogeneous dielectric medium 112 with a refractive index $n_1$=1.49 that is a typical value for glass and plastics in the optical range. Analysis shows that, by optimizing the size, shape and relative positions of the cuboids with respect to the host medium refractive index and wavelength of the incident plane wave, a nanojet beam can be generated with the beam full width at half power (FWHP) of ~ /2$n_1$ and FIE of at least a factor of 5.

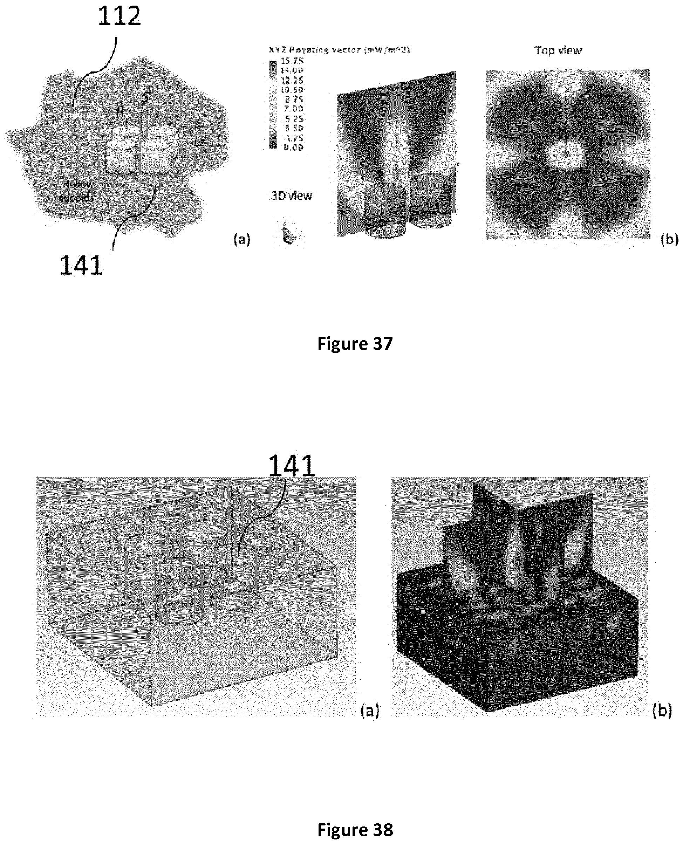

**Figure 37** illustrates an alternate embodiment of light guiding means, in which the hollow rectangular cuboids 140 are replaced with hollow cylinders 141, oriented along the plane wave propagation direction. As in **figure 36, figure 37a** illustrates the topology of such a component, while **figure 37b** provides simulation results of the time-averaged power distribution when the component is illuminated by a unit-amplitude plane wave propagating along z-axis ($n_1$=1.49, $L_z = 2$ $_1$, $R=$ $_1$, $S = 0.5$ $_1$).

**Figure 38** illustrates yet another embodiment, in which a 2x2 array of hollow cylinders 141 is created at the boundary of the dielectric medium 112 and free space, e.g. on the surface of a glass or plastic plate. When illuminated by a plane wave from the media side, such a component produces a nanojet beam in free space close to the surface of the plate 112. This embodiment can be advantageous for applications that require an air gap between the focusing component and the object under test that is a typical scenario for optical data storage, microscopy, spectroscopy, and metrology systems.

As in **figure 37, figure 38a** illustrates the topology of such a component based on a 2x2 array of hollow cylinders created at the interface of the dielectric medium and free space, while **figure 38b** provides simulation results of the time-averaged power distribution when the component is illuminated by a unit-amplitude plane wave propagating along z-axis ($n_1$=1.49, $Lz = 2$ $_1$, $R= 1$, $S = 0.5$ $_1$).

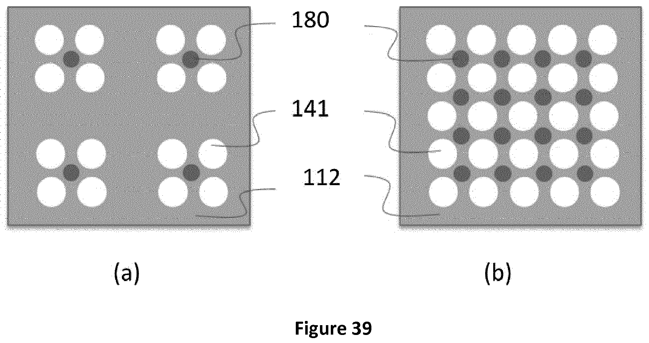

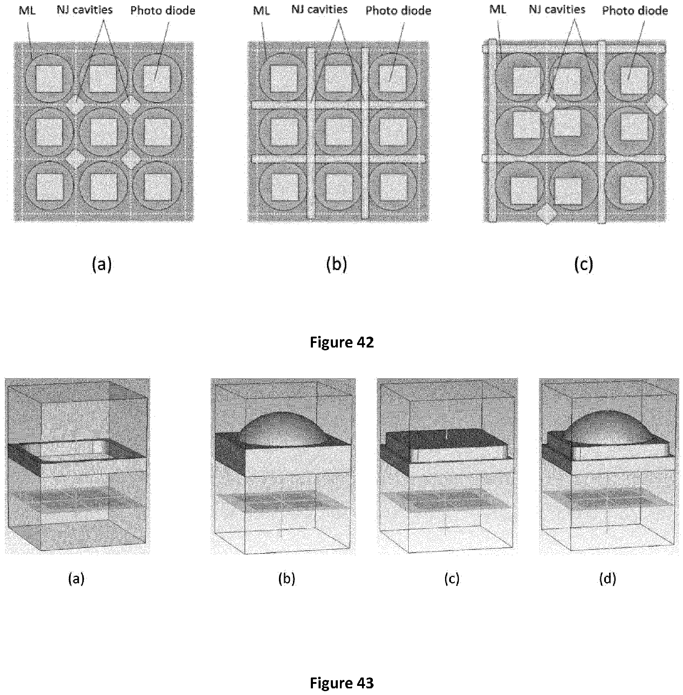

**Figure 39** provides two additional exemplary embodiments based on single-periodic (figure 39a) and double-periodic (figure 39b) arrays of hollow cylinders 141 embedded in a host medium 112, according to one embodiment of the disclosure. In both embodiments, the hollow cylinders form a number of regularly-spaced sub-arrays of 2x2 closely-positioned scatterers that act like the component illustrated in figure 42. Note that in case of figure 39b, each hollow cylinder 141 simultaneously contributes to the formation of four nanojets referenced 180.

In one embodiment of the disclosure, it is proposed to integrate into an image sensor a nanojet focusing element (or light guiding means) as previously described in order to guide light that was considered as loss light in **Figures 1(a)** and **1(b)**.

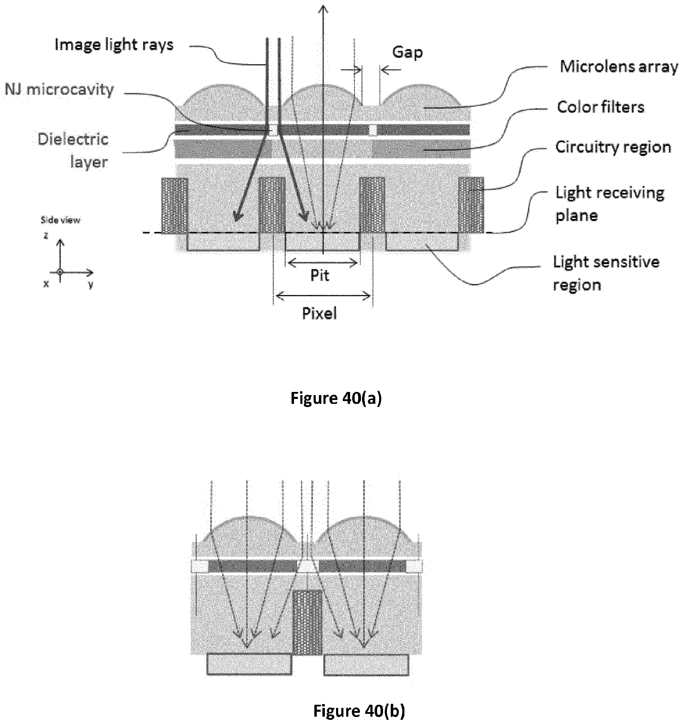

**Figure 40(a)** presents a cross section of three pixels (comprised in a CMOS image sensor covered by microlenses) according to the present disclosure, where the three pixels have a FSI structure, and where a nanojet focusing element (or light guiding means, also named a NJ (nanojet) microlens or NJ microcavities) is integrated in order to guide light that was lost in the prior art (especially in view of **Figure 1(a))**.

**Figure 40(b)** presents the guiding of the lost light in Figure 1(b) via light guiding means according to the present disclosure.

In one embodiment of the disclosure, the light guiding means are positioned in a dielectric layer located between the microlens and the color filter layer in an image sensor.

As depicted in **Figures 40(a)** and **40(b)**, the light guiding means are positioned at the boundary between adjacent pixels, close to the gap formed by two adjacent microlenses in the microlens array.

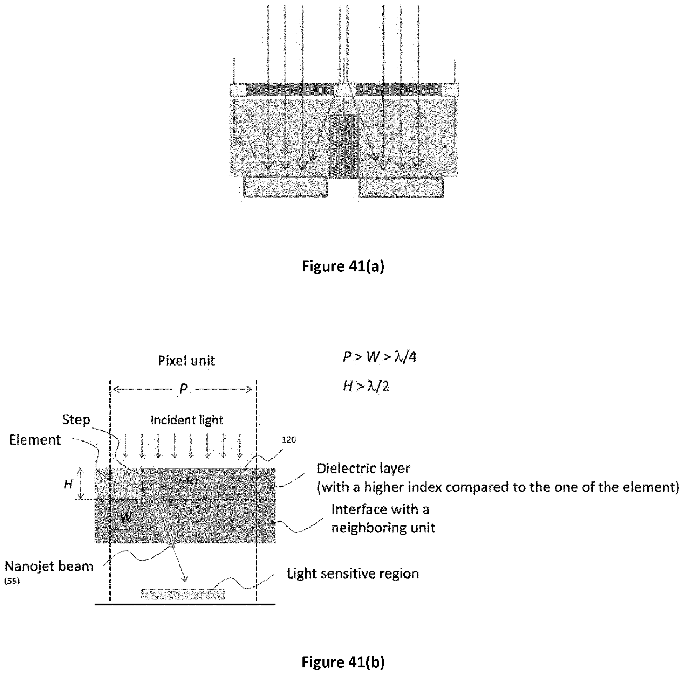

**Figure 41 (a)** presents a pixel architecture that can avoid the use of microlenses due to the use of light guiding means according to one embodiment of the disclosure.

In such embodiment, NJ lenses (or nanojet focusing element) replace the conventional refractive microlenses used in an image sensor. Therefore, it can help to simplify the manufacturing of image sensors. In one embodiment, such nanojet focusing element comprises several cavities in a dielectric material whose size, shape and orientation are chosen in order to guide efficiently the incoming light in the direction of a sensitive element in an image sensor.

**Figure 41 (b)** presents a cross section of a part of a sensing unit (or pixel unit) according to one embodiment of the disclosure.

In the context of an image sensor, and based on the principles for generating a nanojet beam (as explained previously, and especially in Figure 2), it is proposed to use a dielectric layer combined with an element that can be partially comprised in the dielectric layer (the refractive index of the element being lower than the one from the dielectric layer). When an electromagnetic wave is incident on the sensing unit (or pixel unit), a nanojet beam is generated. Such nanojet beam is oriented towards a light sensitive region (i.e. means for converting light into a readable electric signal). The incident light which goes through the center of the pixel unit is not deviated. In such embodiment of the disclosure, the steps are positioned within a pixel unit, but are located away from the surface center of the dielectric layer within the pixel unit, in order to guide light that was lost in the prior art techniques.

**Figure 42** presents a schematic view (top view) of three different embodiments of an image sensor with nanojet focusing elements located at the boundaries of neighboring pixels (not to scale).

For example, the NJ microlenses (or NJ cavities or light guiding means) can be located close to a central pixel as presented in **Figure 42(a)**, and positioned in the corners of such central pixel.

In another embodiment, the NJ microlenses (or NJ cavities or light guiding means) can be positioned in gap (formed by neighboring microlenses) between peripheral pixel units as mentioned in document CN 105791714.

In another embodiment, the NJ microlenses (or NJ cavities or light guiding means) can be created in a form of strips or grooves or rectangular bars between all the microlenses of an image sensor, as depicted in **Figure 42(b)**.

In another embodiment, the NJ microlenses (or NJ cavities or light guiding means) can be positioned as a combination of strips or grooves and cavities between some or all the microlenses of an image sensor, as depicted in **Figure 42(c)**.

The shape of individual NJ microlenses can also be varied depending on the pixel position in the array in order to take into account different illumination conditions. For instance, this can be done by shifting the cavity position with respect to the pixel axis, like in document US 8921964.

The shape of each NJ microlens can also be adjusted in accordance with the structure of each individual pixel and its illumination conditions, i.e. image light incident angle. Such an individual tuning of NJ microlenses is possible thanks to planar topology of the NJ focusing elements that is compatible with established molding and photolithography techniques. Note that such an individual tuning is not always possible with refractive MLs whose fabrication often involves a thermal melting phase that defines the shape of MLs based on the physical properties of the material (e.g. viscosity when in a liquid phase).

The **Figures 43 to 45** present different configuration of nanojet focusing elements that can be used in an image sensor according to one embodiment of the disclosure.

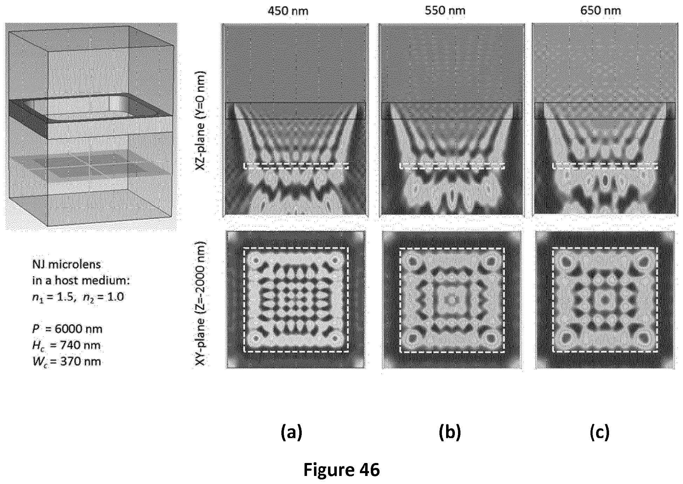

The **Figures 46 to 49** present simulated data obtained using a full-wave 3D-FDTD method that validate the proposed concepts.

Four different configuration are considered: Indeed, **Figure 43** presents: **(a)** a nanojet focusing element in a form of a ring-type cavity in an unbounded dielectric medium, **(b)** the prior art refractive microlens on top of a dielectric substrate, **(c)** a rectangular ring-type nanojet focusing element in a form of a groove on top surface on the substrate, **(d)** a combination of a refractive lens and a nanojet focusing element on the substrate.

More precisely, the nanojet focusing element in a form of a ring-type cavity in an unbounded dielectric medium presented in Figure 43(a) can comprises either structures described in Figures 2 to 13, or structures described in Figures 14 to 35, or a combination of these structures depending of the architecture of a pixel unit and the size of the light sensitive regions.

In all simulations, the pixels are considered as a unit cell of a periodic array. The array is illuminated by a linearly-polarized plane wave incident from above normal to the substrate.

The light capture efficiency of the pixels is estimated as a ratio between the power incident on the receiving aperture and the total power received by the full aperture:

$$\eta = I_2/I_1 \qquad \text{(equation 6)}$$

$$I_i = \int_{S_i} E^2(x, y) ds \text{ with } i = 1,2,$$

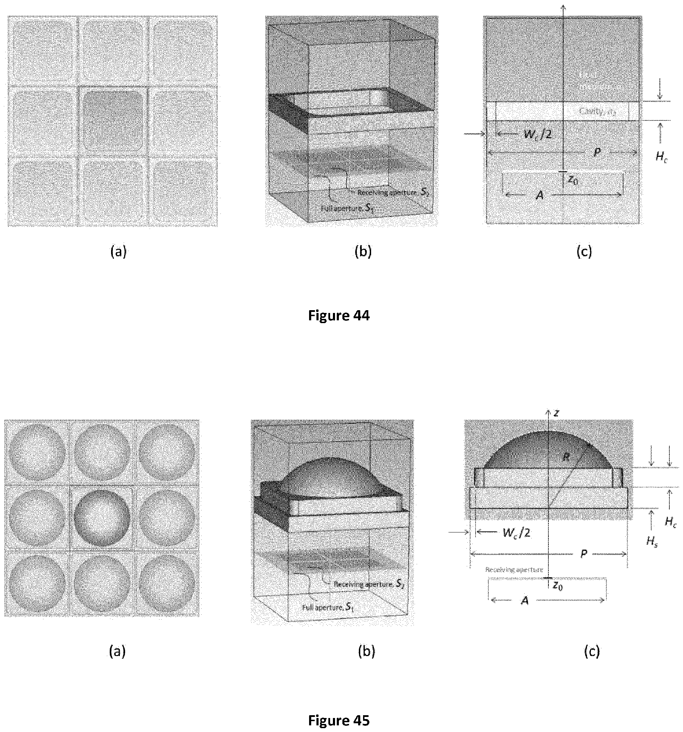

where $E$ is the magnitude of the electromagnetic field, and $S_1$ and $S_2$ are the surface area of the receiving aperture and full aperture of the pixel, respectively (see the notations in **Figure 44(b))**.

**Figure 44** discloses topology and notations of the nanojet focusing element in the form of a ring-type cavity in a dielectric host medium: **(a)** top view on the periodic array, **(b)** 3-D model of the array unit cell with a ring-type nanojet focusing element, **(c)** side view of the unit cell and notations.

**Figure 45** discloses topology and notations of a simplified model of a pixel with refractive and nanojet focusing element: **(a)** top view on the periodic array, **(b)** 3-D model of the pixel with refractive microlens and nanojet focusing element, **(c)** side view of the pixel and notations.

**Figure 46** presents normalized near-field intensity patterns of the ring-type nanojet focusing element illustrated in Figure 44 in the vertical XZ and horizontal XY planes when illuminated by a plane wave from above computed using 3D-FDTD method: **(a)** at 450 nm, **(b)** at 550 nm, **(c)** at 650 nm.

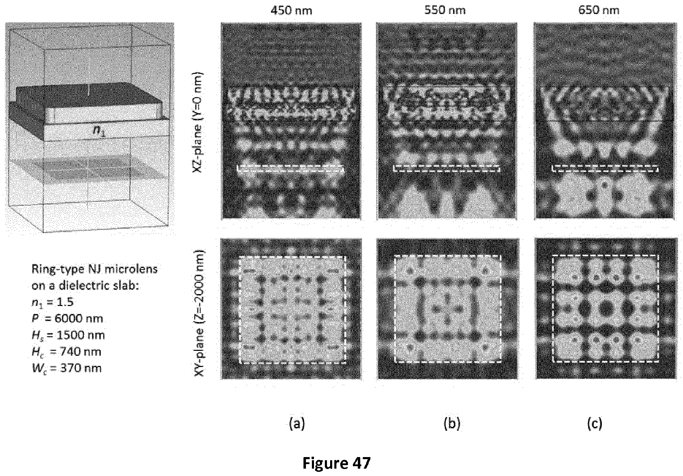

**Figure 47** presents normalized near-field intensity patterns of the ring-type nanojet focusing element in a form of a groove on top of the substrate (see notations in Figure 45) in the vertical XZ and horizontal XY planes when illuminated by a plane wave from above computed using 3D-FDTD method: **(a)** at 450 nm, **(b)** at 550 nm, **(c)** at 650 nm.

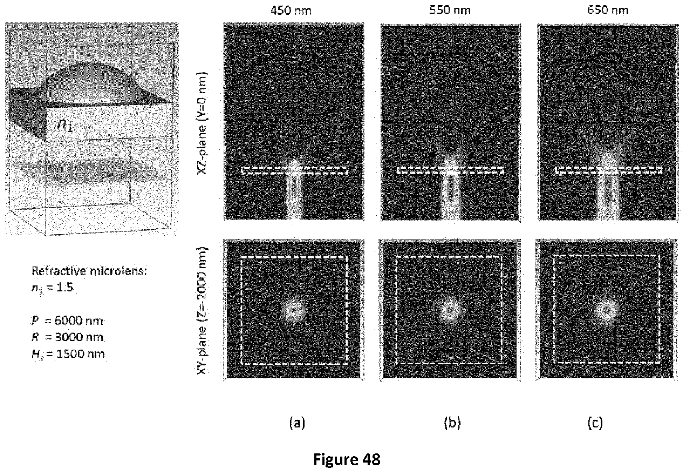

**Figure 48** presents normalized near-field intensity patterns of a refractive hemispherical microlens on top of the substrate (see notations in Figure 45) in the vertical XZ and horizontal XY planes when illuminated by a plane wave from above computed using 3D-FDTD method: **(a)** at 450 nm, **(b)** at 550 nm, **(c)** at 650 nm.

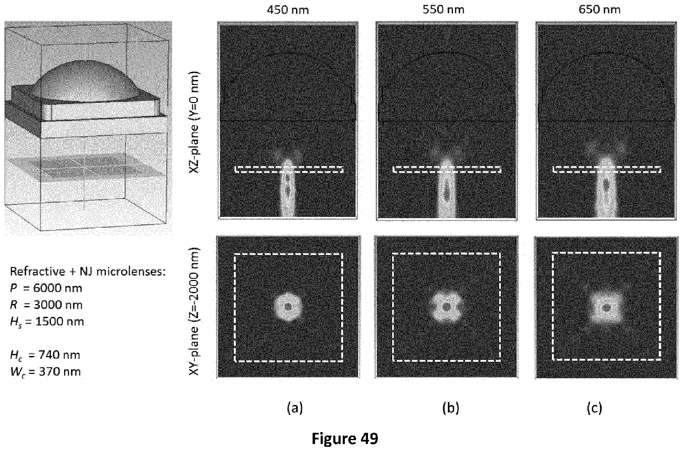

**Figure 49** presents normalized near-field intensity patterns of the combined nanojet focusing elements comprising a hemispherical refractive microlens and NJ microlens in a form of a groove (see notations in Figure 45) in the vertical XZ and horizontal XY planes when illuminated by a plane wave of from above computed using 3D-FDTD method: (a) at 450 nm, (b) at 550 nm, (c) at 650 nm.

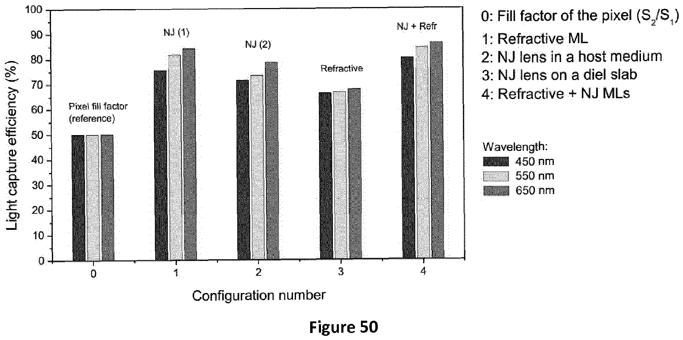

**Figure 50** presents the light capture efficiency values of the pixels presented in **Figures 46-49** determined from the ratio between the power incident on the receiving aperture and the total power received by the full aperture (i.e. from equation 6).

At last, in one embodiment of the disclosure the light guiding means (being a nanojets generating element or a ring-type nanojet element) can be used in a BSI pixel structure.

In another embodiment of the disclosure, the light guiding means can be integrated in the color filter.

In another embodiment of the disclosure, the light guiding means can replace the shielding element in document US 9497397, and be located at the same position.

In one embodiment of the disclosure, the image sensor is comprised in an electronic device for acquiring image data (such as a camera, a mobile phone, a tablet, etc.). In addition, such electronic device comprises a computing unit (for example a CPU, for "*Central Processing Unit*"), and one or more memory units (for example a RAM (for *"Random Access Memory"*) block in which intermediate results can be stored temporarily during the execution of instructions a computer program, or a ROM block in which, among other things, computer programs are stored, or an EEPROM ("*Electrically-Erasable Programmable Read-Only Memory*") block, or a flash block). Computer programs are made of instructions that can be executed by the computing unit. Such electronic device can also comprise a dedicated unit, constituting an input-output interface to allow the electronic device to communicate with other devices. In particular, this dedicated unit can be connected with an antenna (in order to perform communication without contacts), or with serial ports (to carry communications with "contacts").

**Claims**

1. An image sensor comprising at least one sensing unit, said at least one sensing unit comprising means for converting light into a readable electric signal, the image sensor being **characterized in that** said at least one sensing unit comprises light guiding means for guiding light in direction to said means for converting light into a readable electric signal, said light guiding means comprising:

   - at least one layer of a dielectric material (112), having a first refractive index ($n_1$) with a surface having at least one abrupt change of level forming a step, and
   - an element having a second refractive index ($n_2$) lower than said first refractive index ($n_1$), which is in contact with said step.

2. The image sensor according to claim 1, wherein it further comprises at least two sensing units, and wherein the light guiding means of each of these two sensing units are at least partly positioned close to an interface region separating the two sensing units.

3. The image sensor according to claim 1, wherein it further comprises at least two microlenses, each microlens covering a sensing unit, and wherein the light guiding means of each of these two sensing units are at least partly positioned in a neighborhood of said at least two microlenses.

4. The image sensor according to claim 1, wherein said light guiding means completely cover a top of said at least one sensing unit, the top of said at least one sensing unit being a part distant from the means for converting light into a readable electric signal compared to other parts of said at least one sensing unit.

5. The image sensor according to claims 1 to 4, wherein said means for converting light into a readable electric signal correspond to at least one photodiode.

6. The image sensor according to any claims 1 to 5, wherein it further comprises a color filter, and wherein said light guiding means are positioned either below or above or merged with said color filter.

7. The image sensor according to any claims 1 to 6, wherein said at least one sensor unit corresponds to a CMOS image pixel.

8. The image sensor according to any claims 1 to 7, wherein said step is formed by an edge of at least one cavity made in said at least one layer of dielectric material, and said cavity is at least partly filled in with said element.

9. The image sensor according to claim 8, wherein said at least one cavity is a through-hole in said at least one layer of dielectric material, and it comprises a substrate layer supporting said at least one layer of dielectric material.

10. The image sensor according to any claims 8 to 9, wherein said at least one cavity belongs to at least one set of at least two cavities.

11. The image sensor according to any claims 8 to 9, wherein said at least one cavity is targeted to be cylindrical or cone or prism-shaped.

12. The image sensor according to claim 11, wherein said cavity is targeted to be circular or polygonal cylindrical shaped, or circular cone or polygonal cone shaped.

13. The image sensor according to any claims 7 to 12, wherein a width W of said at least one cavity, in a cross-section, is targeted to be such that $W > \frac{\lambda_1}{2}$, where $\lambda_1$ is a minimum wavelength of an electromagnetic wave incident on said dielectric material.

14. The image sensor according to any claims 1 to 13, wherein a height H of said step is targeted to be such that $H > \frac{\lambda_1}{2}$, where $\lambda_1$ is a minimum wavelength of an electromagnetic wave incident on said dielectric material.

15. The image sensor according to any claims 1 to 14, wherein said dielectric material belongs to the group of materials with low dielectric loss comprising:

- glass;
- plastic;
- a polymer material;
- an organic or inorganic optically transparent electrically conducting material;
- ceramics.

16. The image sensor according to any claims 1 to 15, wherein said element having said second refractive index lower than the one of said dielectric material belongs to the group comprising:

- glass;
- plastic;
- polymer;
- a liquid;
- a gas;
- a gel.

17. An electronic device for acquiring image data, said electronic device being **characterized in that** it comprises an image sensor according to any claims 1-16.

**Figure 1(a)**

**Figure 1(b)**

**Figure 2**

Figure 3

**Figure 4**

| 450 nm | 500 nm | 550 nm | 600 nm | 650 nm |
| --- | --- | --- | --- | --- |
| (a) | (b) | (c) | (d) | (e) |

**Figure 5**

**Figure 6**

**Figure 7**

**Figure 8**

$L_z$ = 370 nm     $L_z$ = 740 nm     $L_z$ = 1110 nm

(a)     (b)     (c)

Figure 9

$\theta$ = 0°     $\theta$ = 10°     $\theta$ = 20°     $\theta$ = 30°

(a)     (b)     (c)     (d)

Figure 10

(a)                                    (b)

**Figure 11**

(a)  (b)  (c)  (d)

**Figure 12**

Circular  Square  8-shape  Rectangular

(a)  (b)  (c)  (d)

**Figure 13**

**Figure 14**

**Figure 15**

(a)

(b)

(c)

(d)

**Figure 16**

(a)

(b)　　　　(c)　　　　(d)　　　　(e)

**Figure 17**

(a)

(b)

(c)

(d)

(e)

**Figure 18**

(a)

(b)

(c)

(d)

(e)

(f)

**Figure 19**

Figure 20

Figure 21

λ₀ =450nm  λ₀ =550nm  λ₀ =650nm

(a)  (b)  (c)

**Figure 22**

Power density distribution along Z-axis (mW/m²)

(a)

(b)

(c)

(d)

**Figure 23**

Power density (mW/m²)

Power density (mW/m²)

(a)

(b)

**Figure 24**

**Figure 25**

(a)  (b)  (c)  (d)

**Figure 26**

**Figure 27**

(a)

(b)

(c)

(d)

**Figure 28**

**Figure 29**

**Figure 30**

**Figure 31**

**Figure 32**

Figure 33

(a)

(b)

XY plane (Z=-100 nm)
— along Y-axis
···· along X-axis

BWHP = 150 nm

(c)

Photoresist

BWHP = 530 nm

(d)

Figure 34

(a)

(b)

**Figure 35**

(a)

$n_1$=1.49, $Lx$ = $Ly$ = $Lz$=2$\lambda_1$, S = 0.5$\lambda_1$

(b)

**Figure 36**

**Figure 37**

**Figure 38**

180

141

112

(a)

(b)

**Figure 39**

**Figure 40(a)**

**Figure 40(b)**

**Figure 41(a)**

Pixel unit

$P > W > \lambda/4$

$H > \lambda/2$

Step

Element

Incident light

120

Dielectric layer
(with a higher index compared to the one of the element)

Interface with a
neighboring unit

121

Nanojet beam
(55)

Light sensitive region

**Figure 41(b)**

ML   NJ cavities   Photo diode

(a)

ML   NJ cavities   Photo diode

(b)

ML   NJ cavities   Photo diode

(c)

Figure 42

(a)

(b)

(c)

(d)

Figure 43

(a)                    (b)                    (c)

**Figure 44**

(a)                    (b)                    (c)

**Figure 45**

NJ microlens
in a host medium:
$n_1 = 1.5$, $n_2 = 1.0$

$P = 6000$ nm
$H_c = 740$ nm
$W_c = 370$ nm

450 nm    550 nm    650 nm

XZ-plane (Y=0 nm)

XY-plane (Z=-2000 nm)

(a)           (b)           (c)

**Figure 46**

Figure 47

Refractive microlens:
$n_1 = 1.5$

$P = 6000$ nm
$R = 3000$ nm
$H_s = 1500$ nm

450 nm

550 nm

650 nm

XZ-plane (Y=0 nm)

XY-plane (Z=-2000 nm)

(a)

(b)

(c)

Figure 48

Refractive + NJ microlenses:
$P$ = 6000 nm
$R$ = 3000 nm
$H_s$ = 1500 nm

$H_c$ = 740 nm
$W_c$ = 370 nm

450 nm   550 nm   650 nm

XZ-plane (Y=0 nm)

XY-plane (Z=-2000 nm)

(a)   (b)   (c)

**Figure 49**

**Figure 50**

Europäisches
Patentamt

European
Patent Office

Office européen
des brevets

# EUROPEAN SEARCH REPORT

Application Number

EP 16 30 6844

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/044924 A1 (CANON KK [JP]; YAMASHITA YUICHIRO [JP]) 9 April 2009 (2009-04-09) | 1-9, 11-17 | INV. H01L27/146 G02B27/56 |
| A | * paragraph [0028] - paragraph [0056] * * paragraph [0062] - paragraph [0069] * * paragraph [0091] - paragraph [0106] * * figures 1-6,9 * | 10 | |
| X | WO 2007/024580 A2 (MICRON TECHNOLOGY INC [US]; LEE JI SOO [US]; MCKEE JEFF A [US]; MOULI) 1 March 2007 (2007-03-01) | 1-9, 11-17 | |
| A | * paragraph [0033] - paragraph [0035] * * paragraph [0044] * * figures 2,3,10 * | 10 | |
| X | US 2013/093034 A1 (KOKUBUN KOICHI [JP] ET AL) 18 April 2013 (2013-04-18) | 1-12, 15-17 | |
| A | * paragraph [0016] - paragraph [0056] * * paragraph [0062] - paragraph [0066] * * figures 1-2B,4A-4B * | 13,14 | |
| A | VICTOR V. KOTLYAR ET AL: "Photonic nanojets generated using square-profile microsteps", APPLIED OPTICS, vol. 53, no. 24, 20 August 2014 (2014-08-20), page 5322, XP055357764, WASHINGTON, DC; US ISSN: 0003-6935, DOI: 10.1364/AO.53.005322 * the whole document * | 1-17 | TECHNICAL FIELDS SEARCHED (IPC) H01L G02B |
| A | US 9 362 324 B1 (ASTRATOV VASILY N [US] ET AL) 7 June 2016 (2016-06-07) * column 7, line 46 - column 8, line 46 * * abstract; figures 1,4,5 * | 1-17 | |

-/--

The present search report has been drawn up for all claims

| Place of search | Date of completion of the search | Examiner |
|---|---|---|
| Munich | 6 June 2017 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 16 30 6844

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FARZANEH ABOLMAALI ET AL: "Design and optimization of focal plane arrays integrated with dielectric microspheres", 2016 IEEE NATIONAL AEROSPACE AND ELECTRONICS CONFERENCE (NAECON) AND OHIO INNOVATION SUMMIT (OIS), 1 July 2016 (2016-07-01), pages 258-261, XP055378574, DOI: 10.1109/NAECON.2016.7856808 ISBN: 978-1-5090-3441-3 * the whole document * ----- | 1-17 | |
| | | | **TECHNICAL FIELDS SEARCHED (IPC)** |

The present search report has been drawn up for all claims

| Place of search | Date of completion of the search | Examiner |
|---|---|---|
| Munich | 6 June 2017 | Kostrzewa, Marek |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

page 2 of 2

## ANNEX TO THE EUROPEAN SEARCH REPORT
## ON EUROPEAN PATENT APPLICATION NO.

EP 16 30 6844

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2017

| Patent document cited in search report | | Publication date | Patent family member(s) | | Publication date |
|---|---|---|---|---|---|
| WO 2009044924 | A1 | 09-04-2009 | CN | 101809743 A | 18-08-2010 |
| | | | EP | 2195844 A1 | 16-06-2010 |
| | | | JP | 5164509 B2 | 21-03-2013 |
| | | | JP | 2009088450 A | 23-04-2009 |
| | | | KR | 20100057695 A | 31-05-2010 |
| | | | US | 2010200738 A1 | 12-08-2010 |
| | | | WO | 2009044924 A1 | 09-04-2009 |
| WO 2007024580 | A2 | 01-03-2007 | TW | 200715544 A | 16-04-2007 |
| | | | US | 2007045511 A1 | 01-03-2007 |
| | | | US | 2009169153 A1 | 02-07-2009 |
| | | | WO | 2007024580 A2 | 01-03-2007 |
| US 2013093034 | A1 | 18-04-2013 | JP | 2013088557 A | 13-05-2013 |
| | | | US | 2013093034 A1 | 18-04-2013 |
| US 9362324 | B1 | 07-06-2016 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9478574 B
- US 2010308427 A
- US 2012200749 A
- CN 105791714
- US 9497397 A
- US 9497397 B
- US 2016126277 A

- US 20150325618 A
- US 2016013229 A
- CN 204011428
- US 2014191113 A
- US 20150311243 A
- US 8921964 A

**Non-patent literature cited in the description**

- **KYUNGHO LEE.** *SNR Performance Comparison of 1.4μm Pixel: FSI, Light-guide, and BSI*
- **SOZO YOKOGAWA.** *Plasmonic Color Filters for CMOS Image Sensor Applications*

- **BENEDIKT STEIN.** *Plasmonic devices for surface optics and Refractive Index Sensing*